(19)

Europäisches
Patentamt
European
Patent Office
Office européen
des brevets

(11) **EP 2 023 372 B1**

(12) **EUROPEAN PATENT SPECIFICATION**

(45) Date of publication and mention
of the grant of the patent:
**06.10.2010 Bulletin 2010/40**

(51) Int Cl.:
***H01J 37/12*** *(2006.01)*   ***H01J 37/21*** *(2006.01)*
***H01J 37/28*** *(2006.01)*

(21) Application number: **07114130.3**

(22) Date of filing: **09.08.2007**

(54) **Electrostatic Lens Unit**

Elektrostatische Linse

Unité de lentille électrostatique

(84) Designated Contracting States:
**DE FR GB**

(43) Date of publication of application:
**11.02.2009 Bulletin 2009/07**

(73) Proprietor: **Hitachi Ltd.**
**Tokyo (JP)**

(72) Inventor: **Blackburn, Arthur**
**Cambridge, Cambridgeshire CB3 1HN (GB)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(56) References cited:
WO-A-00/67290      WO-A-2007/096505
DE-A1-102004 032 451   US-A- 5 122 663
US-B1- 6 313 905

• LUETHI R ET AL: "PARALLEL NANODEVICE FABRICATION USING A COMBINATION OF SHADOW MASK AND SCANNING PROBE METHODS" APPLIED PHYSICS LETTERS, AIP, AMERICAN INSTITUTE OF PHYSICS, MELVILLE, NY, US, vol. 75, no. 9, 30 August 1999 (1999-08-30), pages 1314-1316, XP000868227 ISSN: 0003-6951

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to an electrostatic lens unit for a charged particle beam system particularly, but not exclusively, a scanning electron microscope system.

Scanning electron microscopes (SEMs) can be used in a variety of applications to obtain high-resolution (e.g. < 1 μm) images of a sample.

In an SEM, an electron gun emits a primary electron beam in which electrons have a high energy, typically of the order of 1 or 10 keV. An electron optics system comprising an arrangement of lenses and deflectors focuses and scans the beam across the sample with a typical spot size of the order of 10 nm. The fine beam interacts with a small volume of the sample causing it to emit low-energy secondary electrons, along with other scattered electrons, which are collected by a detector. The number of electrons emitted by the sample depends on a number of factors including orientation of the surface and the atomic number of atoms interacting with the beam. Thus, an image of the surface of the sample can be obtained.

In many types of SEM, high-energy electrons are used to generate secondary electrons. In other words, the energy of the primary electron beam is maintained or varied only to a small degree (e.g. by a factor of 2 to 5) before the beam strikes the sample.

Using high-energy electrons (i.e. $\geq$ 1 keV) can help to reduce the spot size and sensitivity to stray magnetic fields. However, using high-energy electrons can have disadvantages, such as causing the sample to charge up, which can impair image quality and/or altering the electronic properties of the sample, such as charge distribution, which can change the characteristics of the sample, for example by causing a shift in threshold voltage of a field effect transistor.

If low-energy electrons (i.e. $\leq$ 100 eV) are used, particularly very-low energy electrons (i.e. $\leq$ 20 eV), then image contrast becomes strongly dependent upon electronic band structure and crystal structure of the material surface. This can yield additional information which is useful for investigating, for instance, new catalysts and novel electronic materials.

A cathode lens situated between the objective lens and the sample and which applies a retarding electric field can be used to reduce the energy of electrons in the primary electric field. The cathode lens is placed as close as possible to the sample (i.e. the "working distance" is reduced as much as possible) to minimise exposure of low-energy electrons to stray magnetic fields and to reduce aberration.

US-A-5 789 748 describes an SEM having a micro-lens unit which includes a retarding electrode situated 100 μm from the sample and which reduces the energy of the primary beam from 10 keV to 100 eV. However, this arrangement suffers the drawback that the retarding electrode is attached to the sample surface using a spacer.

EP-A-1 134 771 describes an electron source capable of operating at low beam energies, e.g. of a few electronvolts, and which could be positioned close to a sample. However, the electron optics of the system are somewhat primitive compared with commonly-used SEMs and so beam characteristics, e.g. beam width, can be inferior.

It has been suggested to combine a charged particle beam system with an atomic force microscope and reference is made to "Concept of deterministic single ion doping with sub-nm spatial resolution" by J. Meijer et al., Applied Physics A, volume 83, pages 321 - 327 (2006). This document proposes an arrangement for deterministically implanting single ions into a substrate. The proposed arrangement includes a linear Pauli trap, an extraction electrode, an Einzel lens mounted on a reverse side of an atomic force microscope (AFM) cantilever. The AFM cantilever and tip are pierced and it is proposed that not only can ions be accurately placed on the substrate, but also the number of ions implanted can be counted. However, this arrangement is not suitable as an electrostatic lens for an SEM, not least because the beam cannot be scanned since the tip would stop the beam for even small beam deflections.

WO-A-2007096505 (Article 54(3) EPC) describes an arrangement comprising a specimen holder, a mask having a through-hole between upper and lower faces of the mask for allowing charged particles to pass through the mask and onto the specimen holder and a near-field detection device for detecting a relative position between the mask and the specimen holder. The mask includes at least one electrode in the through-hole.

WO-A-0067290 describes apparatus for surface inspection and processing of a wafer includes a microcolumn and an associated scanning probe microscope. The microcolumn and scanning probe microscope can be partially fabricated out of the same substrate.

The present invention seeks to provide an improved electrostatic lens unit.

According to a first aspect of the present invention there is provided an electrostatic lens unit for a charged particle beam system including a substrate having first and second opposite faces and a passage extending between first and second openings in the first and second faces respectively, first and second face electrode supported on the first and second faces respectively, and a surface probe cantilever, formed by a slot in the substrate extending between the first and second opposite faces, the cantilever supporting a tip for sensing sample separation when the sample is adjacent the second face, wherein the cantilever is laterally spaced from the passage, wherein the first and second face electrodes are arranged around the respective openings to the passage and arranged on and around the cantilever.

Thus, using the probe, the second face of the electrostatic lens unit can be controllably positioned close to a sample so as to reduce the working distance. However, the probe does not interfere with scanning since it is laterally offset from the electrodes. The lens unit can be used to retard a primary beam of charged particles and so the exposure of low-energy charged particles to stray magnetic fields can be minimised.

The substrate may include an insulating sheet and may comprise first and second portions, wherein the first portion is thicker than the second portion. The first portion may have a thickness of at least $5\mu$m and the second insulating sheet portion may have a thickness no more than 5 $\mu$m. The first portion of the substrate may support the second insulating sheet portion around a peripheral edge.

The first and second portions may share a layer of insulating material, for example which comprises silicon nitride. The first region may comprise another layer of material, such as silicon. The second region need not include the second layer of material.

The substrate may be arranged to provide a cantilever extending from the first portion to the second portion

The unit may comprise at least two electrodes supported on the second face arranged in a stack and around the openings to the passage. For example, the unit may comprise third, fourth and fifth electrode supported on the second face and arranged in a stack and around the openings to the passage.

The probe (e.g. a functional part at which separation is sensed, such as a tip or an electrode) may be spaced apart from the apertures so as not to obscure the aperture. The probe and the aperture may be spaced apart by at least 10 $\mu$m, at least 20 $\mu$m or at least $50\mu$m. The probe and the aperture may be spaced apart by at least $100\mu$m.

The substrate may be planar and may be stepped.

According to a second aspect of the present invention there is provided apparatus comprising the lens unit, a means for supporting a sample and means for positioning the holder.

The apparatus may further comprise means for positioning the electrostatic unit relative to the sample holder. The apparatus may further comprise a laser arranged to direct light onto the unit and a detector arranged to detect light reflected off the lens unit.

According to a third aspect of the present invention there is provided a charged particle beam system apparatus positioned downstream of an objective lens.

According to a fourth aspect of the present invention there is provided a method of operating a charged particle beam system which includes an electrostatic lens unit comprising a substrate having first and second opposite faces and a passage extending between first and second openings in the first and second faces respectively, first and second face electrodes supported on the first and second faces respectively, and a surface probe cantilever formed by a slot in the substrate extending between the first and second opposite faces, the cantilever supporting a tip for sensing sample separation, wherein the first and second electrodes are arranged around the respective openings to the passage and arranged on and around the cantilever, the method comprising sensing separation between the lens unit and a sample, directing a charged particle beam through the lens unit onto the sample and controlling the electrostatic lens unit to influence the charge particle beam including grounding the first electrode and applying a retarding potential to the second electrode and the sample.

The method may further comprise adjusting the separation between the lens unit and a sample while sensing the separation using the probe.

The method may comprise determining topography of the sample using the probe prior to scanning the charged particle beam. The method may further comprise adjusting the separation between the lens unit and the sample and/or controlling the electrostatic lens unit so as to change focus in dependence upon said topography.

Embodiments of the present invention will now be described, by way of example, with reference to the accompanying drawings in which:

Figure 1 is a schematic diagram of a scanning electron microscope system including an embodiment of a lens unit in accordance with the present invention;
Figure 2 is a cross-sectional view of the lens unit shown in Figure 1;
Figure 3 is a simplified perspective view of the lens unit shown in Figure 1;
Figure 4 is a partial cut-away view of a lower portion of the scanning electron microscope system shown in Figure 1;
Figures 5a and 5b are cross-sectional views taken along lines A - A' and B - B' in
Figure 4;

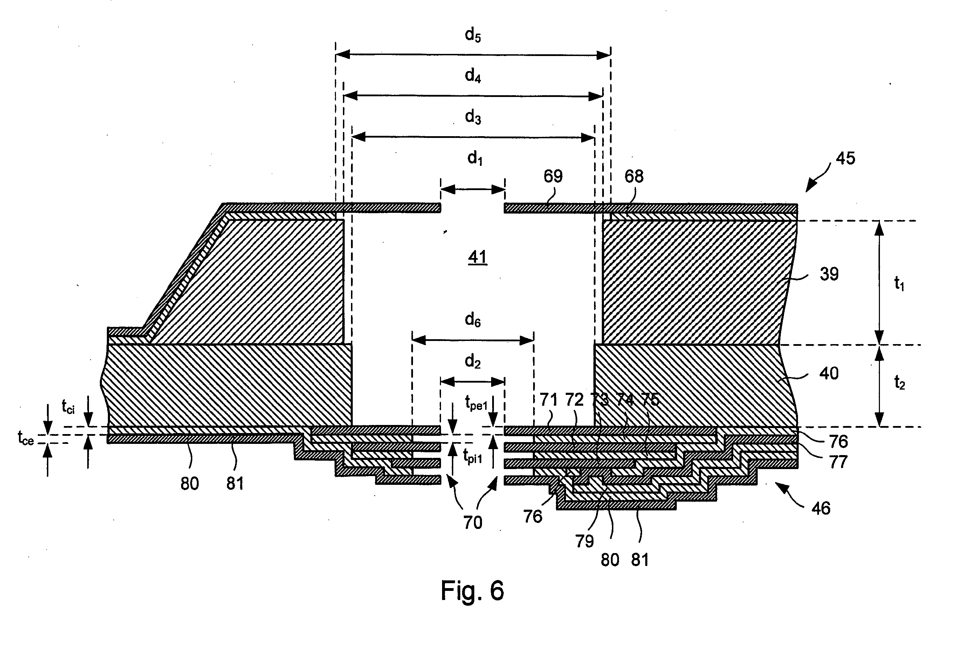

Figure 6 is a detailed cross-sectional view of the electrode arrangement shown in
Figure 2;

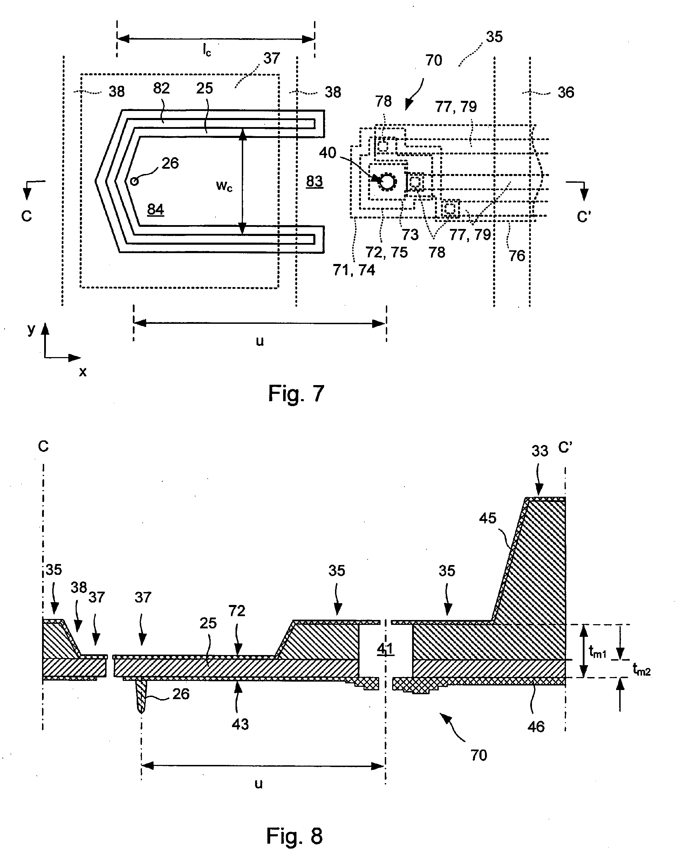

Figure 7 is a plan view of a cantilever and electrodes of the lens unit shown in
Figure 1;
Figure 8 is a cross-sectional view of a cantilever and an electrode arrangement taken along a line C-C' in Figure 6;

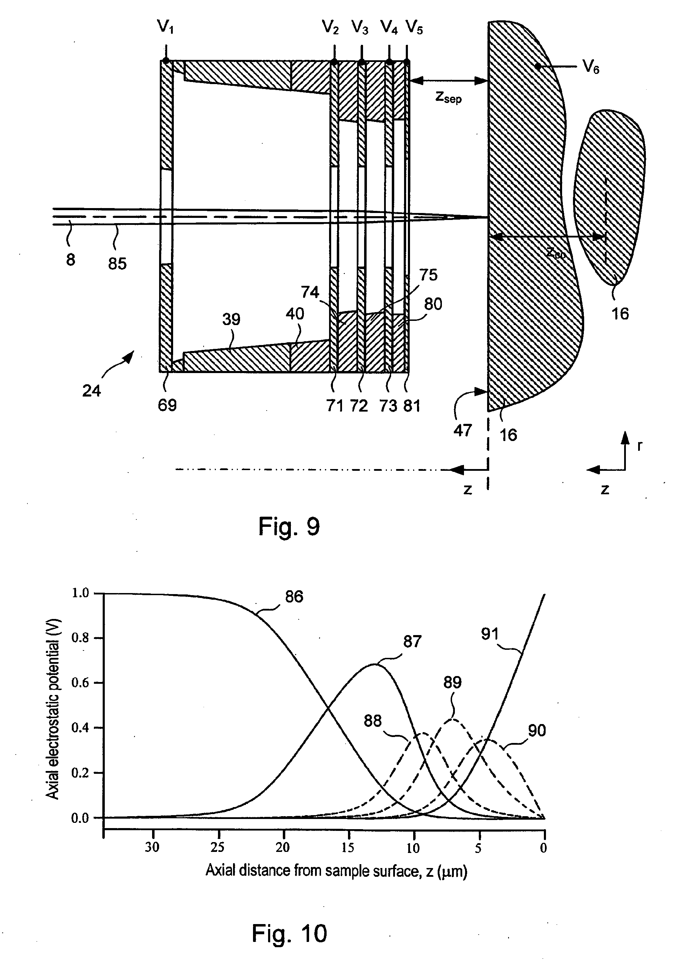

Figure 9 illustrates an electron beam passing through the electrode arrangement shown in Figure 7;
Figure 10 is a graph illustrating variation of electrostatic potentials;

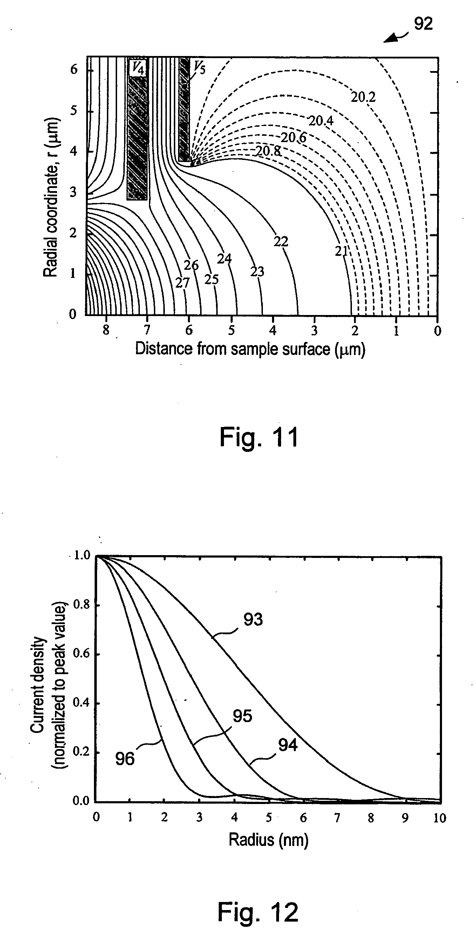

Figure 11 is a plot illustrating equipotential contours in a region above a sample;
Figure 12 is a graph illustrating radial distribution of beam current density;

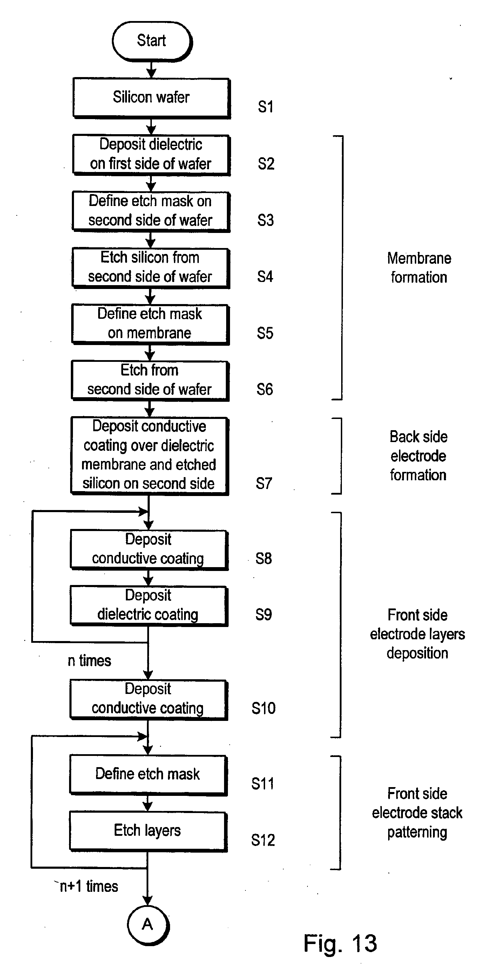

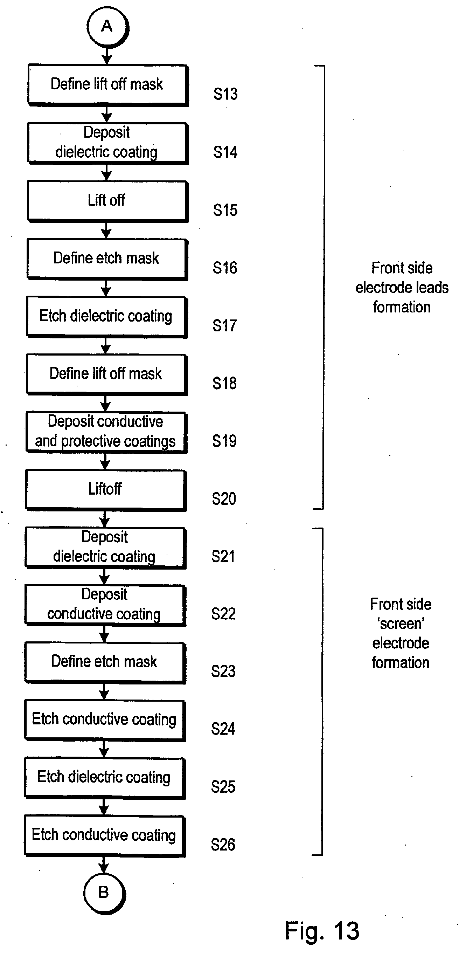

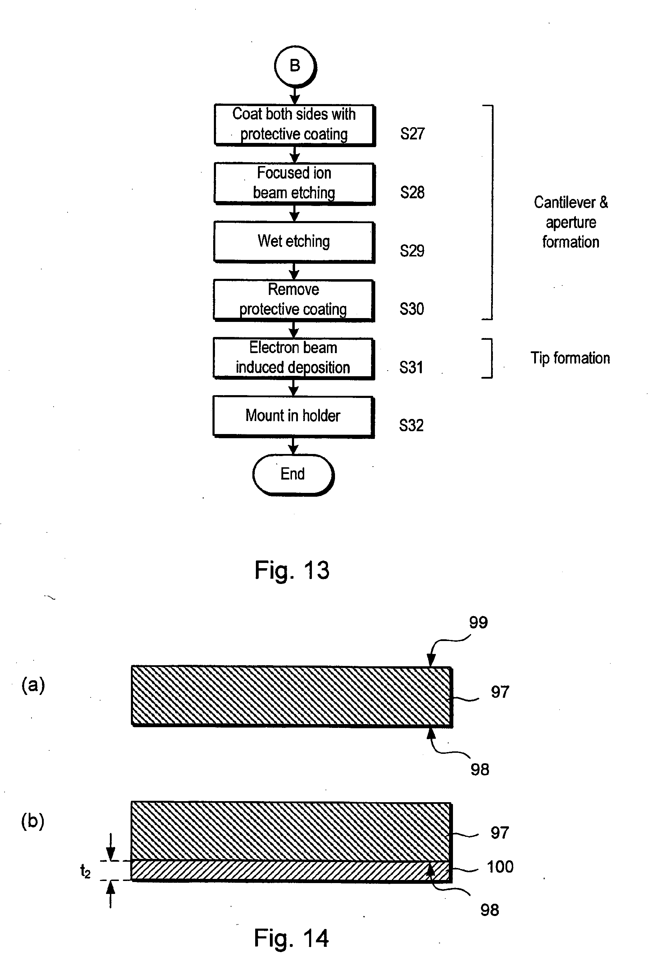

Figure 13 is a flow chart illustrating a method of fabricating a lens stage in accordance with the present invention;

Figures 14a to 14h illustrate a lens stage during different stages of fabrication;

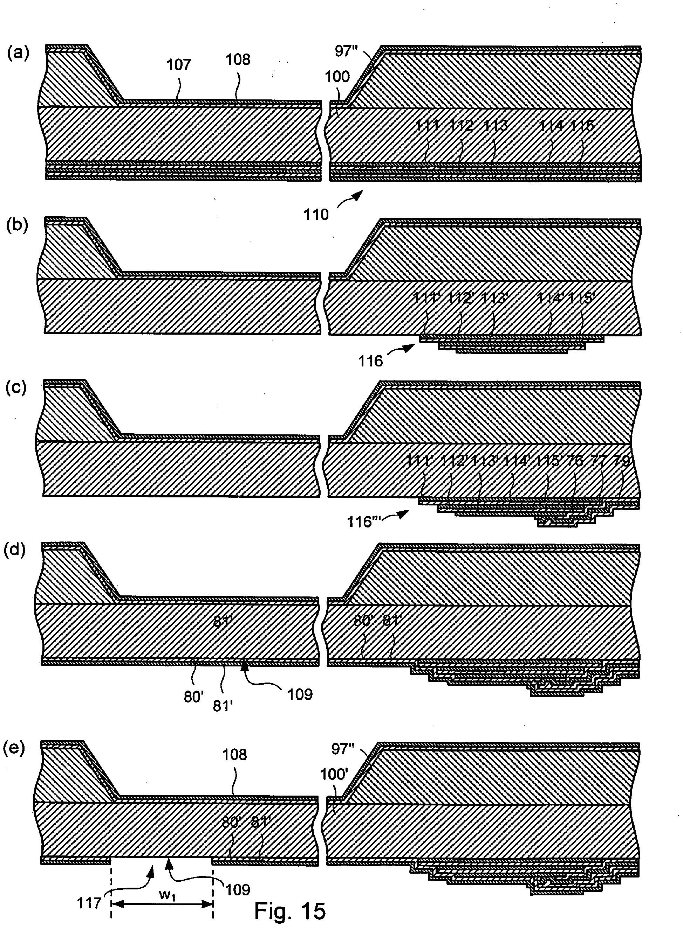

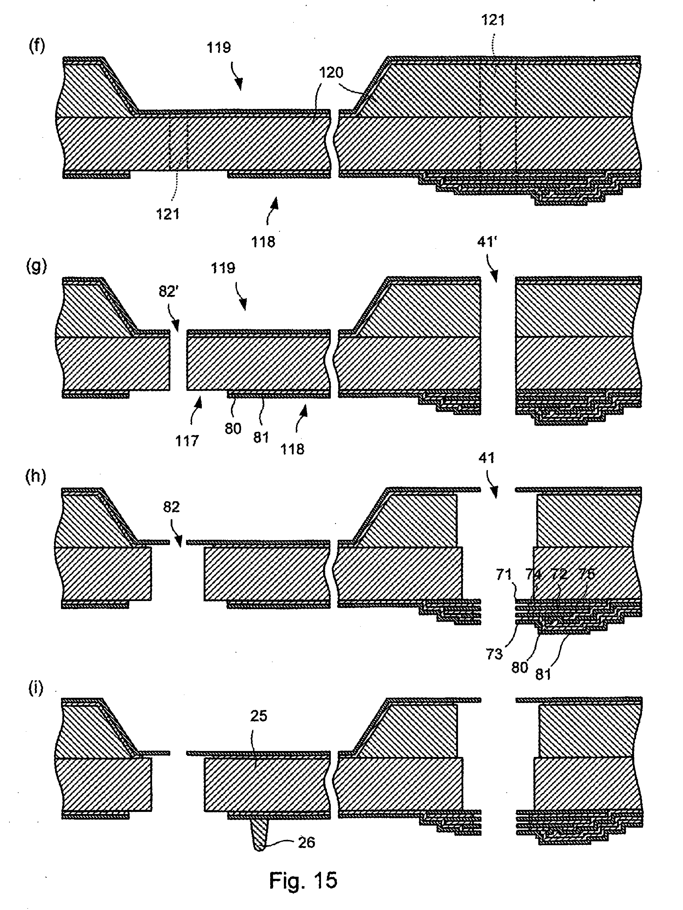

Figures 15a to 15i illustrate a lens stage during different stages of fabrication;

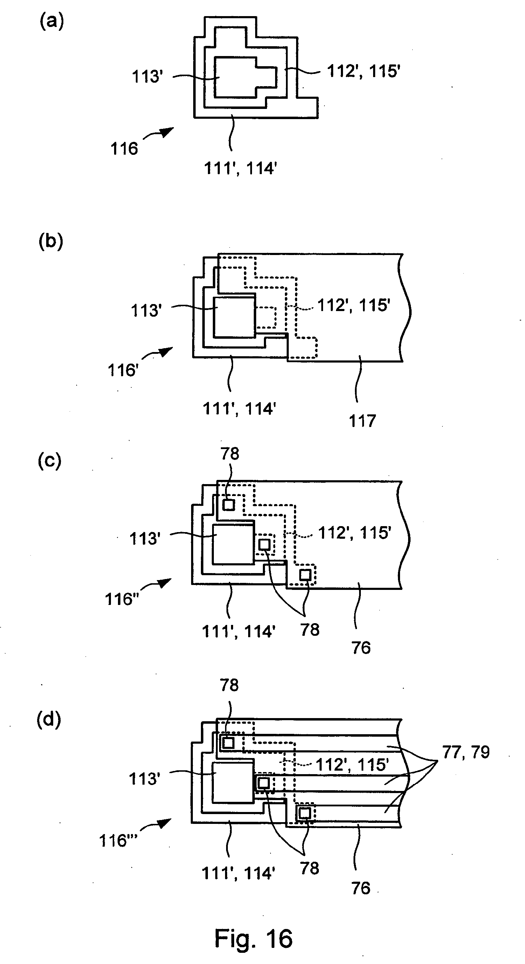

Figures 16a to 16d illustrate a stack of electrodes during different stages of fabrication;

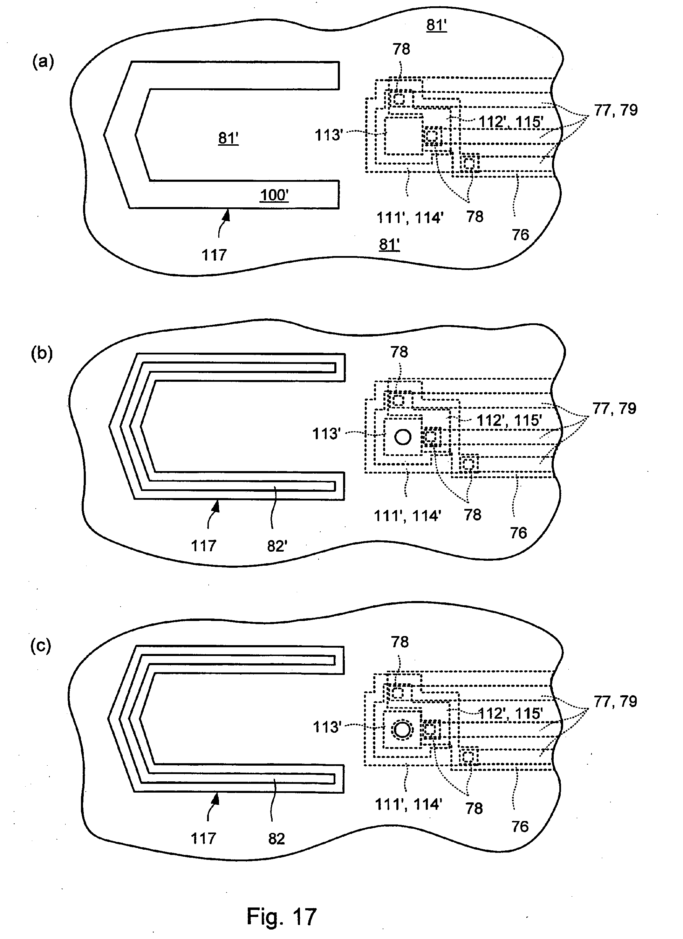

Figures 17a, 17b and 17c illustrate a cantilever and aperture during different stages of fabrication; and

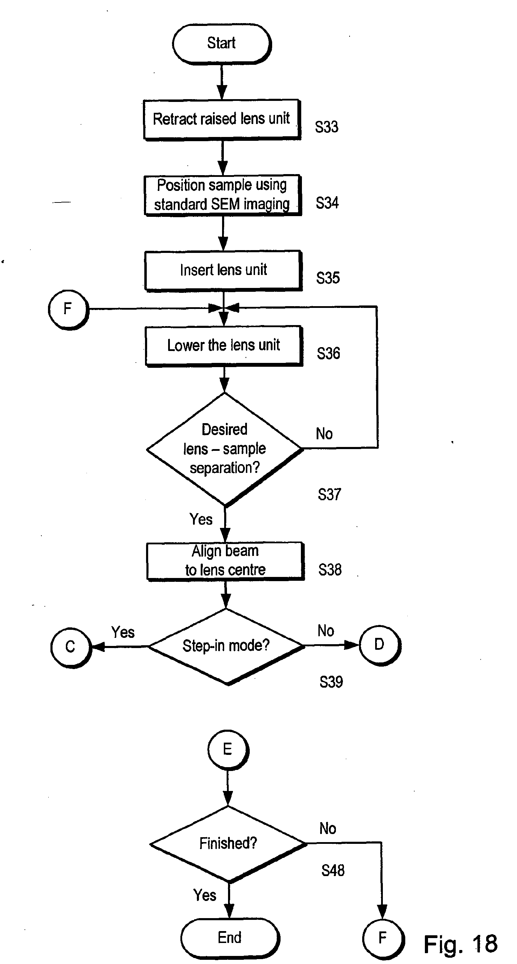

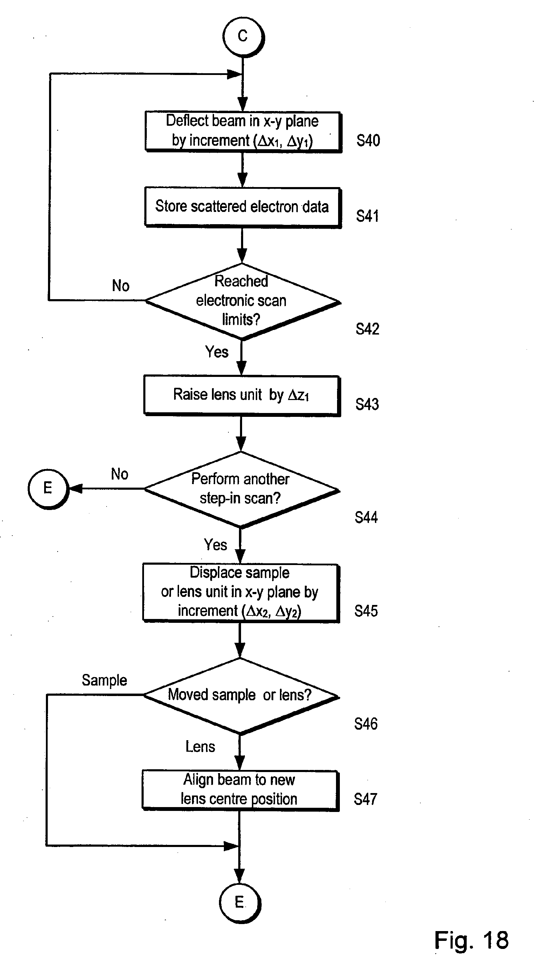

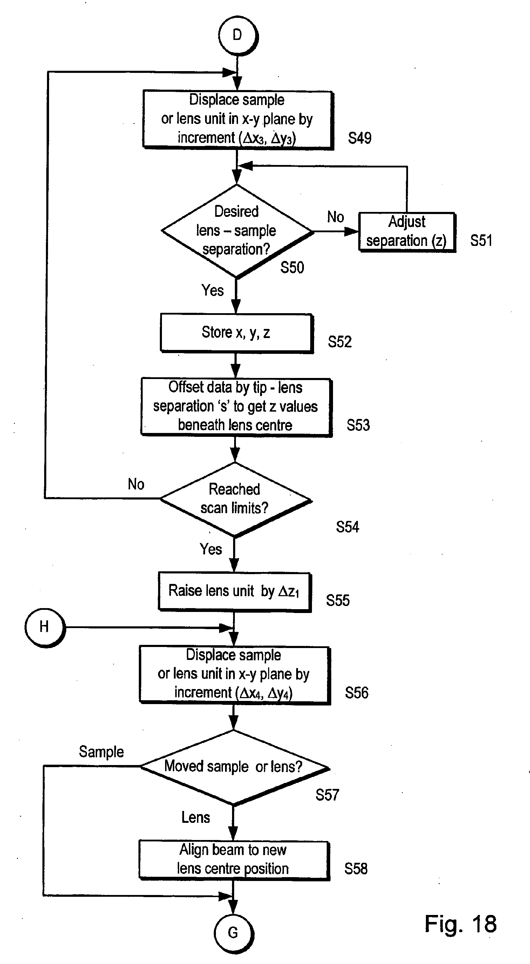

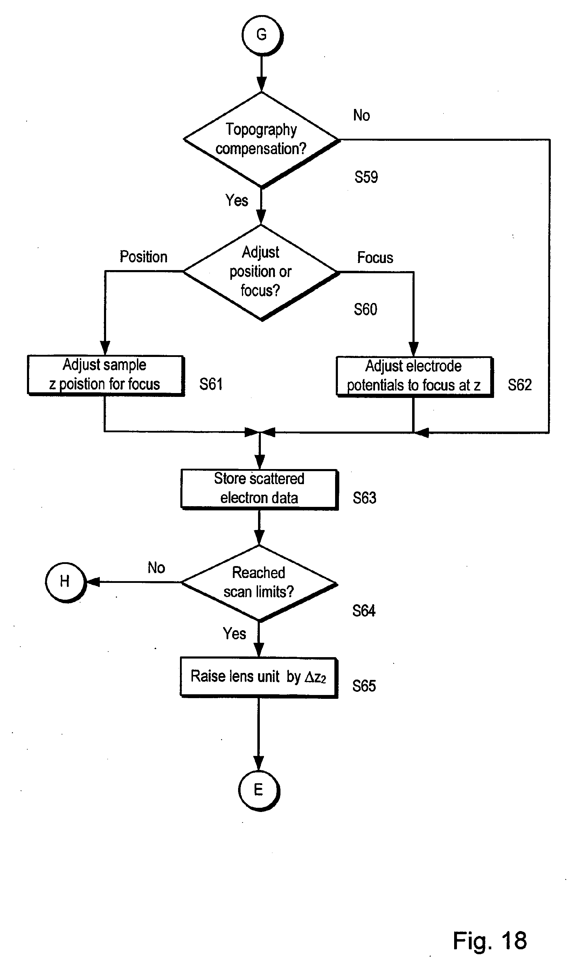

Figure 18 is a flow chart illustrating a method of operating a scanning electron microscope in accordance with the present invention.

*Scanning electron microscope system 1*

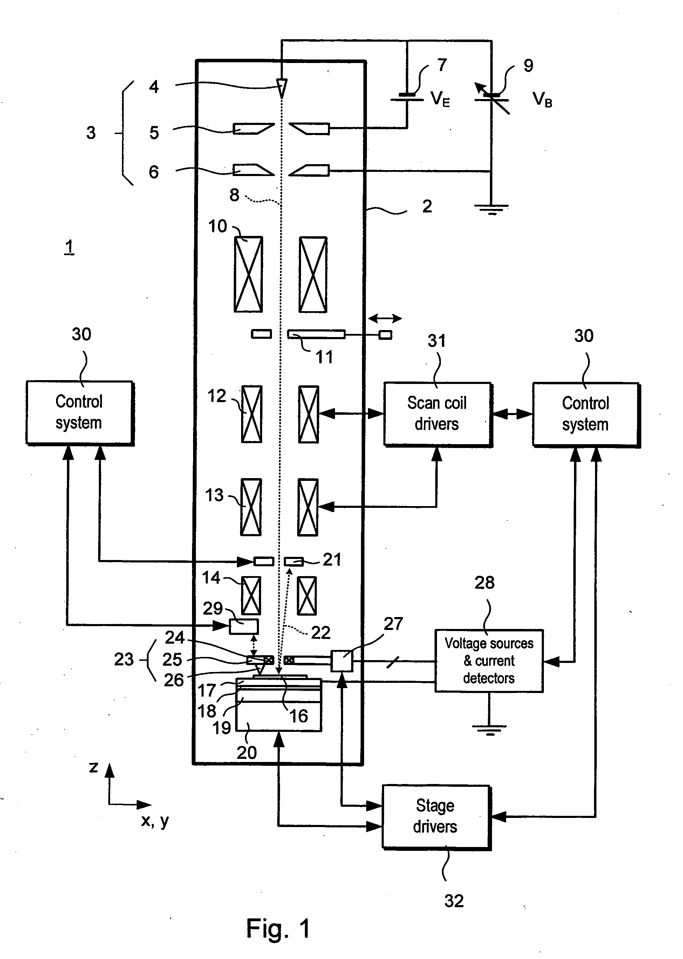

Referring to Figure 1, an embodiment of a scanning electron microscope system 1 in accordance with the present invention is shown. The system 1 includes a housing 2 (usually referred to as the "column") connected to a high- or ultra-high vacuum pumping system (not shown).

At one end, the column 2 houses a cold field emission source 3 comprising a cathode 4, an extraction electrode 5 and an anode 6. A first voltage source 7 is used to apply a bias, $V_E$, between the cathode 4 and the extraction electrode 5 so as to cause the cathode 4 to emit an electron beam 8. A second voltage source 9 is used to apply a bias, $V_B$, between the cathode 4 and a grounded anode 6 so as to accelerate the electron beam 8. Typically $V_E$ is of the order of a 100 V and $V_B$ is of the order of 1 or 10 kV.

The electron beam 8 travels towards the other end of the column 2 through a condenser lens 10, a moveable objective aperture 11, first and second scan coils 12, 13 and an objective lens 14 and is directed onto a sample 16.

The sample 16 is mounted on a support 17 which isolated by an insulating layer 18 from an underlying fine positioning stage 19 which in turn is supported on a coarse positioning stage 20. The fine positioning stage 19 comprises piezoelectric actuators arranged to provide orthogonal directions of movement (usually labelled x, y and z) to an accuracy of better than 1 nm. An example of a fine positioning stage 19 is an ANSxyz100 Scanner available from attocube systems AG, Königinstrasse 11a RGB, 80539 München, Germany. The coarse positioning stage 20 is arranged to provide orthogonal directions of movement between, for example 100 nm to 5 mm. An example of a coarse positioning stage 20 is an ANPx100/NUM Linear Positioner also available from attocube systems AG.

An electron detector 21 is used to detect scattered electrons 22 emitted by the sample 16. In this example, the electron detector 21 is a multi-segment annular semiconductor backscattered electron detector. However, other types of electron detector 21 can be used, such as a conventional scintillator-photomultiplier tube arrangement, Everhart-Thornley detector or a phosphorescent screen with a channel plate multiplier and camera to detect scattered electron patterns. The electron detector 21 may be arranged to detect a low-energy back-scattered electron diffraction (BSED) pattern, also known as a low-energy electron diffraction (LEED) pattern. It will be appreciated that if an annular geometry is used, then any detected pattern misses a central bright-field peak.

A lens stage 23 (or "lens unit") is located between the objective lens 14 and the sample 16. The lens stage 23 has a pass-through, retarding-field lens 24 and a lens-sample separation measuring device in the form of a surface probe cantilever 25 having a tip 26. The lens-sample separation measuring device may take the form of an electrode which allows capacitive sensing of separation. The lens stage 23 is mounted on positioning system 27 which allows the stage to be moved independently of the sample 16.

As will be explained in more detail later, the retarding-field lens 24 can be positioned to within 10 $\mu$m or less from the surface of the sample 16 and be operable to decelerate the electrons in the beam 8 to very low energies (i.e. $\leq 20$ eV). Such a small separation (or "working distance") also helps to provide greater immunity to the effects of external stray dynamic and static magnetic fields.

As will also be explained in more detail later, the scanning probe cantilever 25 is operable in atomic force microscope (AFM) mode and/or in scanning tunnelling microscope (STM) mode. Tip deflection is measured using a position sensing system 29 and/or by measuring probe current using the voltage control and current measurement system 28.

A control system 30 is used to control the retarding-field lens 24 and other drivers, including scan coil drivers 31 and stage drivers 32.

*Lens stage 23*

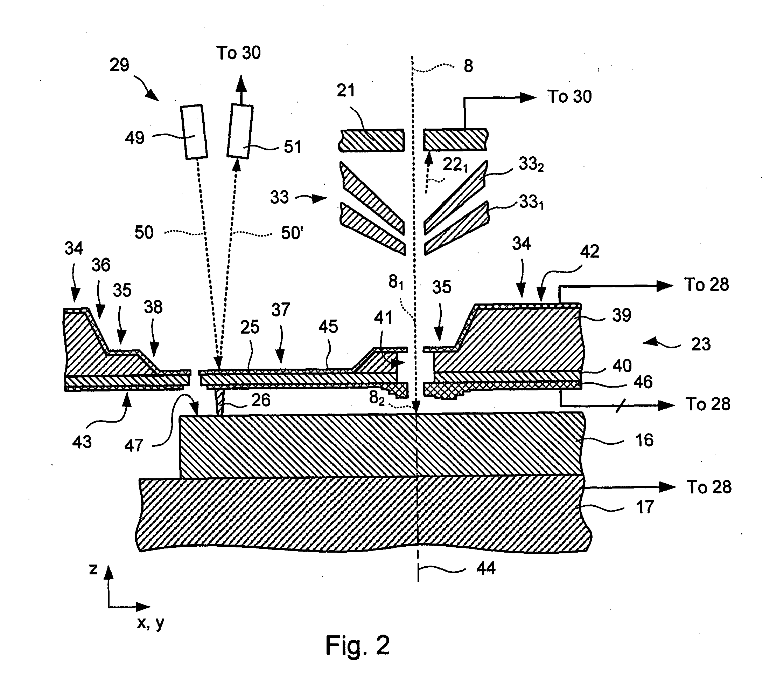

In Figure 2, a lower portion 33 of the objective lens 14, the lens stage 23 and the sample 16 are shown in greater detail. The objective lens 14 includes upper and lower pole pieces $33_1$, $33_2$.

Referring to Figure 2, as explained earlier, the lens stage 23 is positioned between the objective lens 14 and the sample 16.

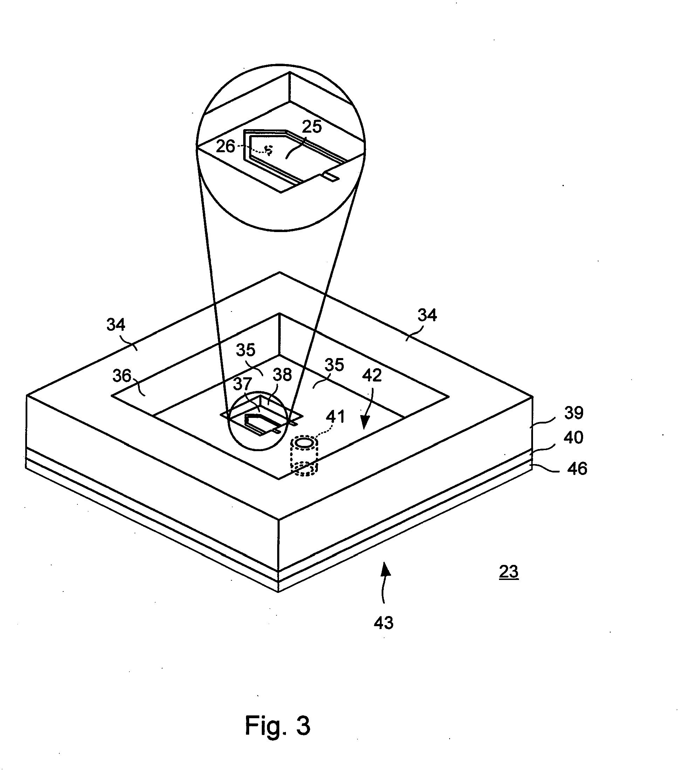

Referring also to Figure 3, the lens stage 23 includes a frame 34 which supports a first sheet portion 35 (herein also referred to as a "base region") around a first perimeter edge 36. The first sheet portion 35 in turn supports a second, thinner sheet portion 37 (herein also referred to as a "membrane") around a second, inner perimeter edge 38.

The frame 34 and the first sheet portion 35 share a layer 39 of rigid, insulating or semiconducting material, which in this example is high-resistivity (e.g. > 10 $\Omega$cm) silicon (Si). Other rigid materials can be used, such as high-resistivity semiconductor materials, glass (i.e. $SiO_2$) or sapphire (i.e. $Al_2O_3$). The frame 34, the first sheet portion 35 and the second sheet portion 37 share a layer 40 of insulating material, which in this example is silicon nitride ($Si_3N_4$), and which preferably has low stress. Other insulating materials can be used, such as silicon dioxide ($SiO_2$).

The first and second sheet portions 35, 37 are generally planar and/or have lateral dimensions (i.e. width and/or length) which are greater than its thickness.

An aperture or passage 41 passes through first membrane portion 35 from a back face 42 (which may also be referred to as the "upstream" face or side) to a front face 43 (which may also be referred to as the "downstream" or "sample" side or face) of the lens stage 23. In this example, the passage 41 has a longitudinal axis which is perpendicular to the faces 42, 43. The tip 26 and aperture 41 are laterally spaced apart. The lens stage 23 is arranged such that the aperture 41 is aligned with the column's optical axis 44 along which the electron beam 8 passes. Alignment will be described in more detail later.

At least a portion of the back face 42 of the lens stage 23 around the aperture 41 supports a first set of overlying layers providing a first electrode structure 45, herein referred to as the "back electrode structure". At least a portion of the front face 43 of the lens stage 23 around the aperture 41 supports a set of overlying patterned layers of conducting and insulating layers providing a second electrode structure or "front electrode structure" 46.

As will be explained in more detail later, during operation, a relatively less negative bias, for example microscope ground potential, is applied to a back electrode 69 (Figure 6) in the back electrode structure 45 and a relatively more negative bias, for example a negative potential, is applied to a front electrode 81 (Figure 6) in the front electrode structure 46 to provide a retarding electric field and to focus the electron beam 8 onto the sample surface 47. Furthermore, negative biases can be applied to other front electrodes 71, 72, 73 (Figure 6) which can provide independent control of primary beam energy and beam focus position. A bias is also applied to the sample support 17, which is typically at the same bias as the electrode 81 (Figure 6) in the front electrode structure 46 closest to the sample 16. Thus, electrons $8_1$ upstream of the lens stage 23 have a higher energy than the electrons $8_2$ incident on the sample 16.

The incident electrons $8_2$ are scattered from the sample surface 47 and some of the scattered electrons $22_1$ pass through the lens stage 23 and are accelerated towards the electron detector 21, which in this example is a multi-segment annular semiconductor back-scattered electron detector mounted perpendicularly to the primary electron beam 8. The output from the electron detector 21 is collected, stored and analysed by the control system 30. A current flowing to or from an electrode 81 (Figure 6) in the front electrode structure 46 closest to the sample 16 (also referred to as a "sample facing electrode" or "surface electrode") can be measured and analysed by the control system 30. Current flowing through the sample 16 may be measured and analysed by the control system 30.

Prior to, during or after electron scattering data has been acquired, surface probe microscopy can be performed using the cantilever 25 supporting a tip 26. For example, to perform scanning tunnelling microscopy, a current flowing between the tip 26 and sample 16 is measured by the control system 30 and is used in a control loop to adjust tip-sample separation, d, to maintain constant current. Tip-sample separation, d (or s), is adjusted using the fine positioning stage 19. An additional or alternative fine positioning stage which supports the lens stage 23 may be used. To perform atomic force microscopy, a diode laser 49 directs a focused laser beam 50 onto the back face 42 of the cantilever 25 and a reflected beam 50' is measured by a photo detector 51. As shown in Figure 2, the laser 49 and photo detector 51 have an optical lever arrangement and so the photo detector 51 is in the form of a four-segment photo diode. However, an interferometer arrangement can be used. Mirrors used for guiding the laser allow the possibility of simultaneous AFM and LEEM. The output from the position detection system 29 is used by the control system 30 to maintain a constant cantilever deflection. In either mode, the signal provided to the fine position stage 19 also provides topographic information about the sample 16. If lateral separation between the lens stage 23 and the tip 26 is known then scanning probe data and scattering data can be correlated. Moreover, the scanning probe data can be used to set electrode potentials for the back electrode 45 and electrode(s) in the front electrode structure 46 so as to provide help to focus the electron beam 8 onto the sample surface 47.

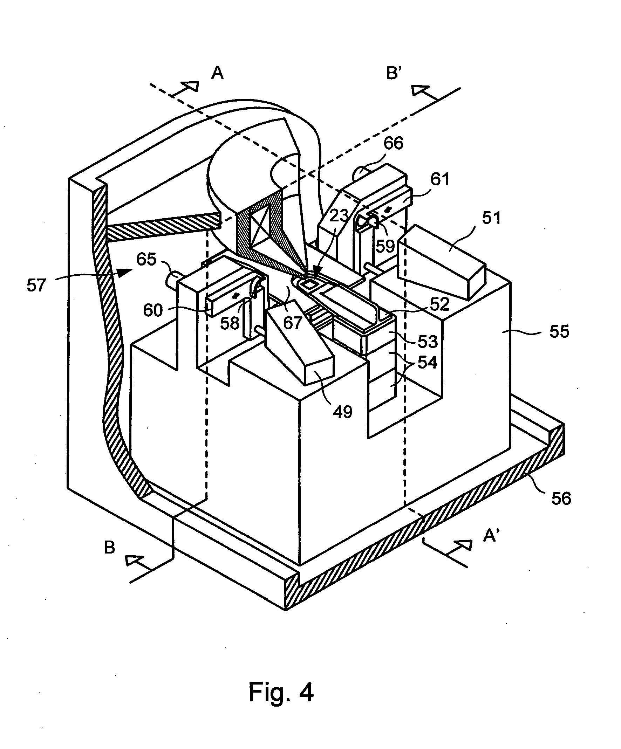

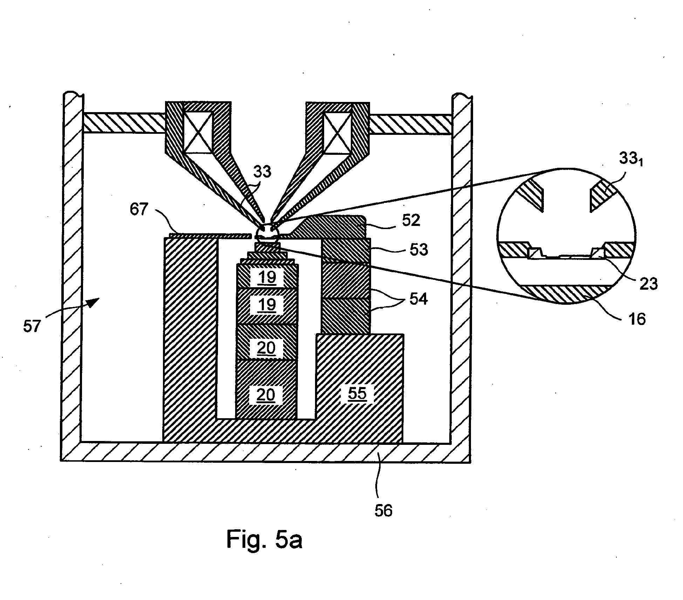

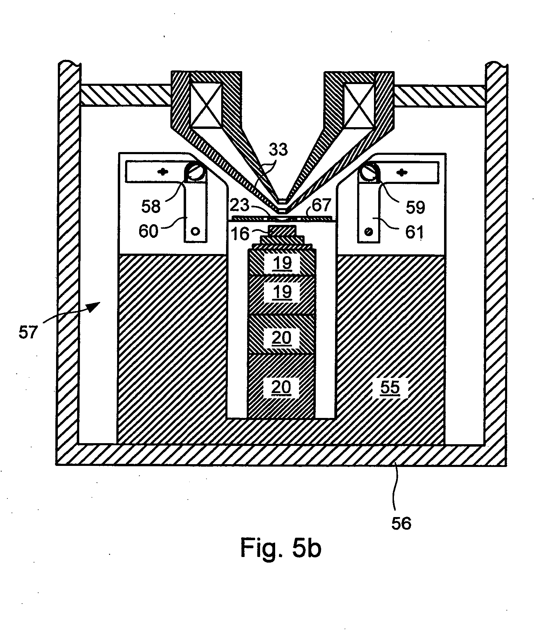

Referring in particular to Figures 4, 5a and 5b, the lens stage 23 is mounted inside the column 2 via a mounting arm 52 which is supported by a fine positioning stage 53, such as an ANSxyz100 Scanner, which is in turn is supported on a coarse positioning stage 54, such as an ANPx100/NUM Linear Positioner.

The coarse positioning stages 20, 54 are supported by a mounting block 55 which stands on the floor 56 of the sample chamber 57.

The position sensing system 28 includes a pair of mirrors 58, 59 supported by respective adjustable mirror mounts 60, 61. Angle of tilt of the mirrors 62, 63 can be adjusted in two planes using, for example, adjustment screws 65, 66. For clarity, only one adjustment screw 65, 66 is shown for each mirror mount 60, 61.

A 'U'-shaped electrostatic shield 67 is placed just above (i.e. upstream) and around the lens stage 23.

Referring to Figures 6, 7 and 8, the back electrode structure 45 includes an insulating layer 68 and an overlying conductive electrode 69. The front electrode structure 46 includes a stack 70 of layers providing electrodes 71, 72, 73 (herein referred to as "primary electrodes") separated by insulating layers 74, 75 (herein referred to as "primary inter-electrode insulating layers" or "primary inter-electrode dielectric layers"). In this example, there are three primary electrodes 71, 72, 73. However, there may be fewer or more primary electrodes.

The stack 70 includes a second patterned layer of conductive material providing a second electrode 71 (which is also referred to herein as the "first front electrode") and an overlying co-extensive layer of insulating material 74, a third patterned layer of conductive material providing a third electrode 72 (or "second front electrode") and an overlying co-extensive layer of insulating material 75 and a fourth patterned layer of conductive material providing a fourth electrode 73 (or "third front electrode"). The fourth electrode 73 partially covers the third electrode 72 which in turn partially covers the second electrode 71. Thus, at least a portion of each electrode 71, 72, 73 is not covered by another electrode which allows a lead to be connected.

A pad of insulating material 76 is used to help reduce cross leakage between one electrode 71, 72, 73 and a contact lead 77 to a different electrode 71, 72, 73. First, second and third vias 78 (Figure 7) provide access through the insulating pad 76 and through respective patterned insulating layers 71, 72, 73 to allow first, second and third contact leads 77 to contact their respective electrodes 71, 72, 73. The contact leads have an overlying insulating layer 79.

An overlying layer of insulating material 80 (herein referred to as the "coating insulating layer" or "coating dielectric layer") covers the stack 70 and contact leads 77 and contact lead insulating layer 79. A fifth layer of conductive material covers the layer of insulating material and provides a fifth electrode 81 (or "fourth front electrode" or "coating electrode") and also a contact to the tip 26.

Using five electrodes 69, 71, 72, 73, 81 can have the advantage that an electron beam cross-over can be formed within the lens stage 23 which enables a near-parallel broad beam to be projected onto the sample surface 47 for parallel imaging. However, use of three electrodes, for example, front electrode 69, first primary electrode 71 and coating electrode 81, still allows independent control of beam energy and beam focus position.

A magnetic prism chamber (not shown), such as one described in US-B-6 878 937, or multi-cell back-scattered electron detector can be used to enable imaging of scattered low-energy electrons in parallel imaging. Further details regarding parallel imaging is given in "Low-energy electron microscopy" by R. M. Tromp, IBM Journal of Research and Development, pp 503 to 516, volume 44 (2000).

As shown in Figure 6, the back electrode 69 has an aperture size, $d_1$, of about 8 $\mu$m, the front electrodes 71, 72, 73, 81 have an aperture size, $d_2$, of about 6 $\mu$m and the insulating layer 40, 41, 68, 72, 74, 80 have aperture sizes, $d_3$, $d_4$, $d_5$, $d_6$, of about 12, 14, 18 and 10 $\mu$m respectively.

The first insulating layer 39 has a thickness, $t_1$, of 10 $\mu$m and the second insulating layer 40 has a thickness, $t_2$, of 2 $\mu$m. The primary inter-electrode insulating layers 72, 74 each have a thickness, $t_{pi1}$, $t_{pi2}$, of 1.5 $\mu$m and the coating insulating layer 80 has a thickness of 0.75 $\mu$m. The primary electrodes 71, 72, 73 each have a thickness, $t_{pe1}$, $t_{pe2}$, $t_{pe3}$ of 0.5 $\mu$m. The coating electrode 81 has a thickness, $t_{ce}$ of 0.25 $\mu$m. The thicknesses may be varied so that a layer can be thicker or thinner.

Referring in particular to Figure 7, the cantilever 25 has a width, $w_c$, of about 50 $\mu$m and a length, $l_c$, of about 100 $\mu$m. As shown in Figure 7, the cantilever 25 is tongue defined by a 'U' shaped slot or cut 82 which starts in the first membrane 35, passes into the second membrane 37 and ends back in the first membrane 35. Thus, the cantilever 25 is anchored at a proximal end 83 in the first thicker membrane portion and extends to a distal end 84 formed of thinner material.

Referring still to Figure 7, the tip 26 and the aperture 41 are laterally separated by a distance, u, of about 100 to 120 $\mu$m. However, the tip 26 and the aperture may be spaced by at least 5 $\mu$m, 10 $\mu$m, 20 $\mu$m, 50 $\mu$m, 100 $\mu$m or 200 $\mu$m.

*Modelling lens operation*

The lens 23 may be modelled to illustrate its operation and to help find lens parameters, such as values of electrode potentials.

Four software packages, produced and marketed by MEBS Ltd., 14 Cornwall Gardens, London, SW7 4AN, United Kingdom, are used to model the lens 23.

Electrostatic modelling is carried out using MEBS SOFEM software. Ray tracing is carried out using MEBS IMAGE software. Using high-accuracy ray trace data, values of spherical and chromatic aberration coefficients $C_S$, $C_C$ can be extracted for given focus and imaging energy conditions. MEBS ABER-5 software can calculate the values of the coefficients $C_S$, $C_C$ using formulae based upon the paraxial ray approximation. Thus, while ABER-5 provides a useful comparison to results obtained from IMAGE, with the low imaging energies and large beam half angles in this arrangement, IMAGE provides more realistic $C_s$ and $C_c$. Finally, MEBS WAVE software is conveniently used to calculate the beam current density profile considering the effects the diffraction, $C_s$, $C_c$, and extended source size.

Electrostatic modelling of lens 23

Referring to Figure 9, the potential distributions of the electrodes 69, 71, 72, 73, 81 and sample 16 is modelled using the SOFEM software package.

Referring also to Figure 10, calculated axial potential distributions 86, 87, 88, 89, 90, 91, i.e. $V_i(z, r = 0)$, for the back electrode 69, front electrodes 71, 72, 73, 81 and the sample 16. As shown in Figure 8, $z_{sep}$ is the separation between the lens 23 and the sample 16.

The axial electrostatic potential distributions 86, 87, 88, 89, 90, 91 are calculated using the model with a unit potential applied to each electrode while the other electrodes are set at 0V. It is also assumed that the environment upstream of the back electrode 69 has the same potential of the back electrode 69. As shown in Figure 9, the potential distributions 86, 87, 88, 89, 90, 91 overlap.

The back electrode 69 and the first primary electrode 71 are mainly used to decelerate incoming electrodes through the application of retarding fields in a controllable manner. Thus, the back electrode 69 can be used to help screen any asymmetric field produced by the sample 16 and the holder 52 (Figure 4) and so minimise perturbations affecting the optical properties of the system.

The rest of the front electrodes, i.e. second and third primary electrode 72, 73 and the final electrode 81, are used to adjust the final focus position of the beam 8 though this may also have some influence on the imaging energy. Some or all of these electrodes can be omitted. However, at least one of these electrodes is needed if independent control of beam energy and beam focus position is required.

The model assumes that the sample 16 is conducting and that the final electrode 81 and the sample 16 are at the same potential. However, this need not be the case. Even so, the model is expected to provide a reasonable approximation of behaviour for a non-conducting sample.

The membrane around the cantilever serves to screen the upper part of the column from the sample when a bias is applied to the sample. Without such screening, the electrostatic field produced by the sample may influence the space above the sample and thus alter the characteristics of the incoming beam 8.

Ray tracing

The lens 24 is modelled using a high accuracy ray tracing software package, namely IMAGE (version 1.3), and a ray equation and aberration integral calculation software package, namely ABER- 5 (version 1.5), which calculates the trajectory of number of primary rays based on paraxial equations. The IMAGE software package uses Hermite fits to enable high order derivatives to the off-axis fields to be calculated to high accuracy allowing the correction to paraxial approximation to be applied.

As will be explained in more detail, the model shows that, for a given working distance, a low-energy electron beam (e.g. $\leq$ 20 eV) can be focused on the sample surface 47 with principal on-axis aberrations and hence a current-density distribution and, therefore, spatial resolution that compares favourably with conventional low energy electron microscopes (LEEMs).

For a given working distance, a value of $V_4$ can be determined so as to focus the beam on the sample. Then $C_S$, $C_C$ etc. can be calculated. In other words, $C_S$ and $C_C$ depend on $V_4$ and $V_4$ depends on working distance.

Calculations are based on the dimensions given earlier, namely the electrode aperture size values $d_1$, $d_2$ and layer thicknesses $t_1$, $t_2$, $t_{pi1}$, $t_{pi2}$, $t_{ci}$, $t_{pe1}$, $t_{pe2}$, $t_{pe3}$, $t_{ce}$ specified earlier.

The calculations determine the current-density distribution in the plane of the sample surface 47. It is assumed that the incoming primary focused electron beam 8 has a virtual cross over at a distance, $z_{co}$, of 40$\mu$m beneath the sample surface 47, a semi-angle of 5 mrad, beam energy of 500 eV with a Gaussian energy distribution of 0.5 eV 1/e full width, i.e. typical of cold field emission source.

The back face electrode 69 is maintained at microscope ground, i.e. $V_1 = 0$ V, and the front face electrode 65 and sample 16 are arranged to be more negative, i.e. $V_1 > V_5$, $V_6$. The second and third primary electrodes 55, 56 are set such that $V_2 - V_1 = -400$ V and $V_3 - V_1 = -480$ V. Within these constraints the sample 16 can be freely set to a potential, $V_6$, to determine the electron beam energy at the sample surface, $E_S$, for example $E_S = 20$ eV and $V_6 = -480$ V.

Two methods of high-accuracy ray tracing and ray equation and aberration integral evaluation are used, namely IMAGE and ABER-5 respectively, to determine the potential, $V_4$, of the third primary electrode 73 to position a Gaussian image on the sample surface 47 of an object at $z = 14z_{sep}$, where $z_{sep}$ is the separation between the lens and the sample 16. These methods also provide aberration coefficients used in determining beam size.

Before modelling is described in more detail, one of the results of modelling will be briefly presented.

Referring to Figure 11, an electric potential distribution 92 above the sample surface 47 is shown for $E_S = 20$ eV, $V_4 - V_6 = 27.5$ V and $V_5 = V_6$. The full line contours are lines of equipotential in steps of 1V between 21 V and 42 V relative to $V_6$. The dashed lines are line equipotential in steps of 0.1 V between 20.1 V and 20.9 V relative to $V_6$. As shown in Figure 11, close to the optical axis, i.e. $r < 4\mu$m, the electric field is at most about 0.45 V $\mu$m$^{-1}$. Further from

the optical axis, the electric field falls off rapidly.

The modelling process involves considering a point source of electrons having an initial energy distribution $N_E$ $(E_0)$, where $E_0$ is the initial energy, and determining the current-energy distribution in an image plane, usually referred to as the polychromatic point spread function, $J_{poly}(r)$, given by:

$$J_{poly}(r) = \int \left| \psi(r, E_0) \right|^2 N_E(E_0) dE_0 \qquad (1)$$

where

$$\psi(r, E_0) = \frac{2\pi}{\lambda} \sqrt{\frac{I}{\pi \alpha_1^2}} \int_0^{\alpha_1} \exp\left\{ i \frac{2\pi}{\lambda} \times \left[ \frac{1}{4} C_S \alpha^4 - \frac{1}{2}\left( b_1 + C_C \frac{E_0}{E_S} \right) \alpha^2 \right] \right\} \times J_0\left( \frac{2\pi}{\lambda} r\alpha \right) \alpha d\alpha$$

$$(2)$$

where $I$ is the total beam current, $\lambda$ is the wavelength of the electron beam, $\alpha_1$ is the aperture angle (at the image plane), $\alpha$ is the beam half-angle, $i = \sqrt{-1}$, $C_c$ is the chromatic aberration constant, $C_s$ is the spherical aberration constant, $E_0$ is the initial energy of an electron through the system, $E_S$ is its energy at the specimen plane $b_1$ is the distance from the specimen plane to the Gaussian image plane for zero initial energy, r is the radial coordinate, $J_0$ denotes the Bessel function of the first kind of order zero, and $N_E(E_0)$ is the energy distribution of the emitted electrons.

For an extended electron source, i.e. non point source, with intensity distribution in the image plane given by $\beta(r)$, the current-density distribution is the convolution integral:

$$J_{total}(r) = \iint_A \beta(r_1) \hat{J}_{poly}(\rho) dA \qquad (3)$$

where $\hat{J}_{poly}(\rho) = I J_{poly}(\rho) / (\pi \alpha_1^2)$, $r_1$ is the distance from the central axis to the element of area d$A$ and r is the distance from d$A$ to the point where $J_{total}$ is to be calculated. The brightness distribution can be described by Gaussian distribution:

$$\beta(r) = \beta_0 \exp\left( -\frac{r^2}{r_0^2} \right) \qquad (4)$$

The image-plane brightness distribution $\beta_0$ can be characterised by its 1/$e$ full width, which is often called the effective demagnified source diameter, $D_G$. The effective demagnified source diameter attainable depends on the design details of the column and gun. Modern SEMs provide a resolution of about 5 - 20 nm for an image energy of 500 eV (i.e. without any retarding field) and the lens 23 demagnifies the object by a factor of 3 to 4. Therefore, values of effective demagnified source diameter in the range 2 to 5 nm are considered.

Values of $J_{poly}(r)$ and $J_{total}(r)$ are calculated in this range of effective demagnified source diameter, i.e. $2 < D_G$ (nm) $< 5$, in the low-energy regime, i.e. $2 < E_S$ (eV) $< 20$, and using a beam half angle, $\alpha_1 = 50$ mrad.

The rise distances from 20% to 80% of the total current, $J_{total}(r)$, are extracted from the calculated functions (i.e. as if scanning the beam over a knife-edge) and are tabulated in Table 1 below:

Table 1

| $E_S$ (eV) | $V_4$ (V) | $C_s$ ($\mu$m) | $C_c$ ($\mu$m) | Total current 20 - 80% rise distance for demagnified source size, $D_G$ (nm) | | | | |
|---|---|---|---|---|---|---|---|---|
| | | | | $D_G= 0$ | $D_G= 2$ | $D_G= 3$ | $D_G= 4$ | $D_G= 5$ |
| 20 | 27.5 | 16.8 | 5.27 | 2.5 | 2.9 | 3.3 | 3.8 | 4.3 |
| 10 | 38.8 | 7.3 | 2.66 | 3.2 | 3.5 | 3.8 | 4.2 | 4.7 |
| 5 | 50.3 | 3.3 | 1.37 | 4.4 | 4.6 | 4.8 | 5.1 | 5.5 |
| 2 | 64.2 | 1.3 | 0.58 | 6.6 | 6.7 | 6.9 | 7.1 | 7.4 |

Referring to Figure 11, polychromatic spread functions 93, 94, 95, 96 for an on-axis beam with energies of 2, 5, 10 and 20 eV are shown. The polychromatic point spread function 96 for a beam energy of 20 eV shows the diameter which contains 50% of the beam current, $d_{50}$, is 3.3 nm and that 20 - 80% current rise distance, $S_{R2080}$, is 2.4 nm. If the beam 8 is electrically scanned through the lens unit 23, such as in the step-in mode of operation, described later, then the variation in the beam current density profile, particularly the additional blurring of the beam, with off-axis distance is considered to select an appropriate scan field size.

Those skilled in the art will appreciate that the variation in the beam current density profile depends upon the details of the deflection coils 12, 13 and control system 30 and upstream lens arrangement 10, 14. However, a simple estimate of the off-axis blurring can be provided using MEBS IMAGE software by considering a simple lateral shift of the beam in the lens object plane and, hence, the image (sample) plane. However, it is noted that while this method models the effect of the beam energy and angular distributions, it does not include diffraction effects, which were accounted for in Table 1.

Table 2 below presents the average 20 - 80% current rise distances (blur), $s_{RAv2080}$, at the optimum defocus position, $z_{opt}$, for various off-axis distances, r, in the image plane, for 20 eV imaging energy. The on-axis beam (r = 0) appears slightly smaller than that in Table 1, owing to the earlier calculation including diffraction effects. The optimum defocus value, $z_{opt}$, is the distance (directed upstream) where the minimum beam blur exists, relative to the minimum blur position for the on-axis beam.

Table 2

| | Off-axis distance, r (nm) | | | | | | |
|---|---|---|---|---|---|---|---|
| | 0 | 25 | 50 | 75 | 100 | 125 | 150 |
| Blur, $s_{RAv2080}$ (nm) | 2.2 | 2.3 | 2.6 | 3.7 | 5.1 | 6.3 | 7.8 |
| Optimum defocus, $z_{opt}$ (nm) | - | 0 | 0 | 40 | 80 | 110 | 180 |

Thus, the best rise distance may be obtained by operating with the beam on the central axis and scanning the sample beneath the lens. In this case, the resolution approaches that offered by parallel LEEMs of ~5 nm at 10 eV and offers significant improvement over scanning LEEMs which offer 20 - 30 nm resolution at 20 eV. If the beam is scanned over $\pm$150 nm from the central-axis, an improvement over scanning LEEMs is still offered.

*Fabrication*

Referring to Figures 13 to 16, a method of fabricating the lens stage 23 will now be described.

Referring in particular to Figure 14a, a high-resistivity silicon wafer 97 having a thickness of about 200 $\mu$m is provided which is patterned with alignment markers (not shown) on first and second sides 98, 99 of the wafer 97 (step S1). Offsets between alignment markers (not shown) on each side of the wafer 97 can be measured by comparing them against through holes passing from one side of the wafer 97 to the other. Preferably, front side to back side alignment accuracy is better than +/- 10 $\mu$m.

As shown in Figure 14b, a layer 100 of silicon nitride having a thickness, $t_2$, of 2 $\mu$m is deposited on the first side 98 of the wafer 97 by chemical vapour deposition (step S2).

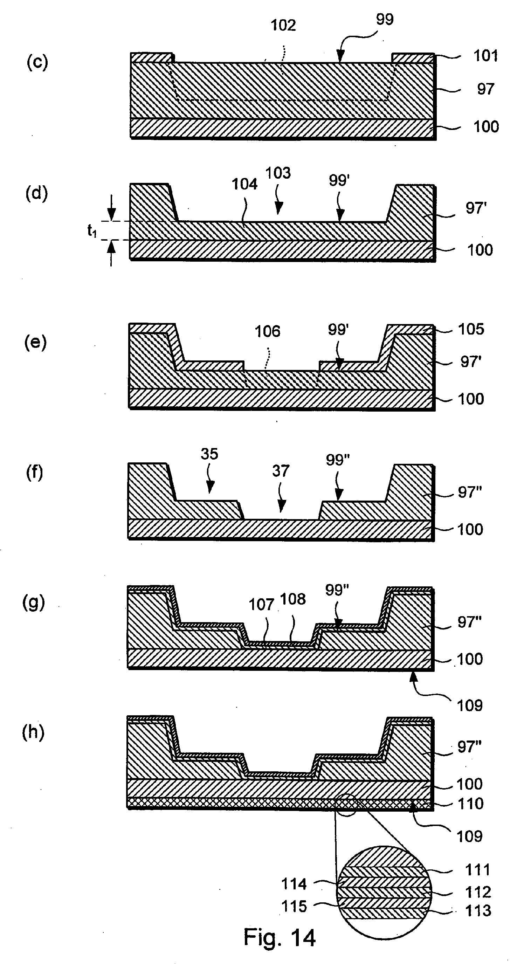

Referring in particular to Figure 14c, a first etch mask 101 is defined on the second side 99 of the wafer 97 (step S3). Preferably, the etch mask 101 comprises a "hard" mask material, such as silicon nitride ($Si_3N_4$) or silicon dioxide ($SiO_2$). Alternatively, the etch mask 101 may comprise a "soft" mask material, such as a photo resist or other polymeric material. The etch mask 101 is patterned (directly or indirectly) using optical lithographic techniques.

A portion 102 of the wafer 97 is etched by a deep reactive ion etching process, for example using silicon hexafluoride ($SiF_6$) and oxygen (02) as a feed gas, or a similar "Bosch"-type process (step S4). Alternatively, an isotropic wet etch, for example comprising a mixture of hydrofluoric acid, nitric acid and acetic acid (sometime simply referred to as "HNA") can be used. The etch mask 101 is removed, although it need not be.

As shown in Figure 14d, etching leaves an etched wafer 97' having a pit 103 , a thinned region 104 of wafer material having a thickness, $t_1$, of 10 $\mu$m and an etched back face 99'.

Referring to Figure 14e, a second etch mask 105 is defined on the etched back face 99' of the etched wafer 97' (step S5). The second etch mask 105 comprises photo resist, although another resist, such as electron-beam resist can be used.

A region 106 of the thinned wafer 97' is etched using a wet etch, such as a mixture of potassium hydroxide (KOH), water ($H_2O$) and isopropanol (step S6).

As shown in Figure 14f, etching leaves a further etched wafer 97".

At this point, first and second membranes 35, 37 are defined, following which, front and back electrodes structures are defined.

Referring in particular to Figure 14g, a layer of silicon dioxide 107 having a thickness of 0.25 $\mu$m is deposited by RF magnetron sputter deposition over the etched back face 99". Following deposition of the silicon dioxide layer, a layer 108 of tungsten (W) having a thickness of 1 $\mu$m is deposited by RF magnetron sputter deposition (step S7).

The silicon nitride layer 100 has a front surface 109.

Referring also to Figure 14h, an electrode stack 110 is deposited over the front surface 109 of the silicon nitride layer 100 by RF magnetron sputter deposition (steps S8, S9 & S10). The deposition conditions are chosen to minimize stress in this stack 110. The stack 110 comprises alternating layers of tungsten 111, 112, 113 and silicon dioxide 114, 115 having thicknesses of 0.5 $\mu$m and 1.5 $\mu$m respectively. The layers 111, 112, 113, 114, 115 are deposited in succession in a chamber (not shown) without breaking vacuum in order to improve interface quality between the dielectric and metal electrode layers.

Referring also to Figure 15a, the electrode stack 110 is shown in more detail.

Successive photoresist etch masks (not shown) are defined and an appropriate numbers of layers etched using appropriate etches (steps S11 & S12).

For example, to define the third primary electrode 73 (Figure 6) the "last" tungsten layer 113 is etched. To define the second primary electrode 72 (Figure 6), in addition to etching the "last" tungsten layer 113, the underlying silicon dioxide layer 115 is etched, followed by the "middle" tungsten layer 112. A potassium ferricyanide based etchant is used to etch tungsten and a hydrofluoric acid based etchant is used to etch silicon dioxide.

As shown in Figures 15b and 16a, etching leaves an etched stack structure 116 comprising etched tungsten layers 111', 112', 113' separated by etched silicon dioxide layers114', 115'. In Figure 15b and 16a, edges of the etched tungsten layers 111', 112' and corresponding paired etched silicon dioxide layers 114', 115' are shown to be co-extensive. However, the edges of the etched tungsten layers 111', 112' may recede under the corresponding silicon dioxide insulating layers114', 115'.

A dual-layer photoresist lift off mask (not shown) comprising PMGI SF6 and Shipley S1813 photo resist are applied and patterned using photolithography (step S13). A layer of silicon dioxide (not shown) having a thickness of 0.25 $\mu$m is deposited over the patterned mask by RF magnetron sputtering (step S14) and the resist and unwanted regions of silicon dioxide are lifted off in NMP (M-methyl-2-pyrrolidone) (step S15).

As shown in Figure 16b, lifting off the resist and unwanted regions of silicon dioxide leaves a patterned silicon dioxide layer 117 which partially overlaps the stack structure 116. This leaves a partially-covered stack structure 116'.

A photoresist etch mask (not shown) is defined (step S16) and the patterned silicon dioxide layer 117 is etched using a hydrofluoric acid based (step S17).

As shown in Figure 16c, etching leaves contact windows 78 having a size of about 3 $\mu$m $\times$ 3 $\mu$m in a patterned silicon dioxide layer117 (Figure 16b). Wet etching helps to provide an etched edge having a smooth rising profile over which contact leads can run. This leaves a modified partially-covered electrode structure 116".

A dual-layer photoresist lift off mask (not shown) comprising PMGI SF6 and Shipley S1813 photo resist is applied and patterned using photolithography (step S18). A layer of gold (not shown) having a thickness of 0.25 $\mu$m followed by a layer of silicon dioxide is deposited over the patterned mask by RF magnetron sputtering (step S19) and the resist and unwanted regions of gold are lifted off in NMP (step S20).

As shown in Figures 15c and 16d, lift off leaves gold contact leads 77 having overlying protective silicon dioxide layers 79 and which run over the underlying silicon dioxide layer 76 and contact, via the contact windows 78, the etched tungsten layers 111', 112', 113' which will form the primary front electrodes 71, 72, 73 (Figure 8). This leaves an electrode structure 116'''.

Referring to Figure 15d, a blanket layer of silicon dioxide 81' having a thickness of 0.75 $\mu$m followed by a blanket layer of tungsten 82' are deposited over the front surface 109 and the electrode structure 116''' by RF magnetron sputtering (steps S21 & 22).

A photoresist etch mask (not shown) is applied over the tungsten layer 82' and patterned using photolithography (step S23). The tungsten layer 82' and silicon dioxide layer 81' are etched using a ferricyanide based wet etch and a hydrofluoric based wet etch respectively (steps S24 & S25). After the hydrofluoric based wet etch, the tungsten layer 82' may be etched further using the ferricyanide based wet etch (step S26) so as to etch back the edge of the overlying tungsten electrode layer 82' so as to cause it to recede beyond the edge of the silicon dioxide layer 81'.

As shown in Figures 15e and 17a, etching leaves a trench 117 exposing the face 109 of the underlying silicon nitride layer 100'. The trench 117 is generally 'U'-shaped and outlines the subsequently-formed slot 82 (Figure 7) used to form the cantilever 25 (Figure 7) so as to help isolate the front and back metallization layers 81,108 (Figure 7) on the cantilever 25 (Figure 7). This is to reduce edge leakage and instances of surface tracking (or "flashover"). As shown in Figure 15e, the width of the trench is $w_1$ and is about 8 to 10 $\mu$m.

Regions (not shown) of the protective silicon dioxide layers 79 close to the edge of the wafer and having an area of the order of 100 $\mu$m $\times$ 100 $\mu$m are also etched to expose regions of the gold layer for each lead 77 for providing bond bad to which wires may be bonded.

Referring to Figure 15f, each side 118, 119 of the processed wafer 120 are coated with a removable protective coating (not shown) such as an azide-based photoresist (step S27).

Regions 121, 122 of the processed wafer 120 are anisotropically etched using a focused ion beam (step S28). The regions 121, 122 extend through the processed wafer 120 from one side 118 to the other 119. As shown in Figure 15f, the width of the ion beam etch is $w_2$ and is about 2 $\mu$m. It is noted that the vertical and horizontal directions are not to scale.

As shown in Figures 15g and 17b, etching forms a cut 82' for defining the cantilever 25 (Figure 5) and an aperture 41'.

The processed wafer 120' is etched using a series of etches, namely a phosphoric acid based etch to silicon nitride, potassium hydroxide and a mixture of hydrofluoric acid, nitric acid and acetic acid etch (or "HNA") to etch silicon, a hydrofluoric acid based etch to etch silicon dioxide (step S29). Each etch does not etch tungsten appreciably.

The protective layer (not shown) covering the underside 118 of the processed wafer 120' sticks to the silicon nitride layer 100 in the trench 117 (Figure 15f). Therefore, the protective layer (not shown) masks the bottom silicon dioxide layer 80 and electrode layer 81 from the wet etches.

As shown in Figures 15h and 17c, wet etching forms a wider cut 82 and a wider aperture 41. In particular, it sets back the edges of the dielectric layers 74, 75, 80 from the edges of the electrodes 71, 72, 73, 81. This can help to reduce charge impaction and the effects of charging.

The protective coating is removed using acetone, rinsed in isopropanol and cleaned using an oxygen plasma (step S30)

The probe tip 26 is deposited by electron beam induced deposition (step S31). Reference is made to "Automated wafer-scale fabrication of electron beam deposited tips for atomic force microscopes using pattern recognition" by J. H. Kindt et al., Nanotechnology, volume 15, page 1131 (2004). Preferably, the probe tip 26 has a length lying in a range between about 5 to 10 $\mu$m and a radius lying in a range between 100 to 200 nm. The tip radius may be smaller. The probe tip 26 may be formed from an organic material such as amorphous carbon. However, the probe tip 26 may be formed form metals or metallic alloys.

The lens stage 23 is then mounted in a holder 52 (Figure 4) and bond wires (not shown) connected.

*Microscope operation*

Referring to Figures 1 and 18, a method of operating the scanning electron microscope system 1 will now be described. Some or all of the steps of the method may be carried out under the control of a computer program (not shown). A user (not shown) may provide some parameters, such as a value of desired lens-sample separation.

The control system 30 positions the lens unit 23 ready for use (steps S33 to S38). The lens unit 23 is withdrawn using the positioning system 27, for example retracting the unit 23 along the x-axis (step S33). This allows the lens unit 23 to be dismounted (e.g. to be replaced) and/or to allow the sample 16 to be mounted or changed. The sample 16 is viewed by conventional SEM and moved into a desired position using the sample positioning system 19, 20 (step S34). Imaging can also be used to obtain other information about the sample. The lens unit 23 is then reinserted so that it is positioned between the objective lens 14 and the sample (step S35). The lens unit 23 is lowered (step S36) while separation between the lens and the sample is monitored using the lens-sample separation sensor (step S36) until the desired separation is achieved, typically when the probe tip is < 10 nm from the sample surface.

As explained earlier, separation may be measured in different ways. For example, if the cantilever 25 and tip 26 is used in AFM mode, then the output from the laser diode 51 (Figure 2) or the current flowing between an electrically-biased tip 25 and the sample 16 may be monitored. The electrical bias may comprise low- ("dc") and high-frequency ("ac") components. Tunnelling and/or field-emission of electrons between the sample 16 and probe tip 26 can be monitored by examining the dc component. Changes in capacitance between a probe 26 and sample 16 can be monitored using the ac signal component and can use sensitive measurements of differential conductance using lock-in amplifier methods.

Once the desired lens-sample separation is achieved, the lens 23 and sample 16 are held stationary while the electron beam 8 is aligned to the centre of the aperture 41 (Figure 2) of the lens unit 23 (step S38). This can be achieved by imaging the back face 42 (Figure 2) of the lens unit 23 using SEM imaging and then placing the beam 8 in "spot" mode to align the beam 8 with the centre of the aperture 41 (Figure 2).

The lens unit 23 may be operated in a so-called "step-in" mode (steps S40 to S47) or a "stationary beam" mode (steps S49 to S65).

In "step-in" mode, the electron beam 8 is scanned, using the deflector coils 12, 13, within a given field size of the lens unit 23. The beam 8 can be scanned, for example, by rastering in increments of $\Delta x_1$ and $\Delta y_1$ (step S40). At each point, scattered electron data, for example sample current, detector current and/or backscattered electron detector current are recorded (step S41). The beam 8 is scanned until the scan of the field has been completed (step S42).

The field size can be selected from Table 2 above based on desired resolution and degree of blur. Resolution can be improved by applying dynamic compensation of the focus conditions, noting the optimum defocus positions in Table 2.

Once a scan is completed, the lens unit 23 is raised by $\Delta z_1$ to a safe working distance (step S43). A check is made as to whether another scan in a different position is required (step S44).

If another scan is required, then the sample 16 or lens 23 is moved from its current position to a new position offset by $\Delta x_2$, $\Delta y_2$ (step S45). If the lens 23 is moved, then the beam 23 is realigned to the lens 23 (step S46).

The lens unit 23 is lowered and another scan is performed (steps S40 to S43).

If no further scanning is required, then operation can be stopped (step S48).

In "stationary beam" mode, information about the topography of the sample 16 is obtained by scanning the probe-tip over the sample surface, while monitoring and keeping the z-separation at a desired level, and storing information about the topography the sample 16, e.g. in terms of x, y and z values (steps S49 to S52). In atomic force microscope mode, a laser bounce detector can be used as the sensor, while the tip-sample separation is maintained at < 10 nm within the limits of the fine positioning stage and control response time. Other topography sensing modes can be used, as described earlier.

The topography information may be processed, for example to obtain separation data (step S53). The tip 26 is scanned (i.e. mechanically scanned) over a given size of field (step S54).

The lens unit 23 is raised by $\Delta z_1$ to a safe distance, for example, to help avoid tip crash (step S55). A scan (i.e. a beam scan) of the sample 16 is performed to collect low-energy electron scattering data as within the loop containing the scanning increment $\Delta x_4$, $\Delta y_4$ (step S56).

If the lens 23 is scanned within this loop, the beam 8 is continually kept aligned with the moving lens unit 23. Using a predetermined path 23 for the lens unit 23, it is possible to synchronize the beam deflection with lens unit 23 displacement.

Topography compensation may be performed during scanning whereby the height of the sample or the electrode potentials can be adjusted so as to ensure that the low-energy electron-beam is focused as best as possible on the sample 16 (steps S59 to S62). The topography information collected earlier (once offset by the separation between the scanning-probe tip 26 and electron beam 8) can used to determine the required adjustment in the z-position (step S61) or electrode potentials (step S62).

During this scanning operation, scattered electron data is collected (step S63), in a similar way to that described earlier in the "step-in" mode of operation. Scanning continues until the desired scan limits have been reached (step S64). It is noted that these limits cannot exceed the travel of the piezo-actuators.

Once the scanning is complete, the lens-unit is raised to a safe separation from the sample surface (step S65).

It will be appreciated that many modifications may be made to the embodiments hereinbefore described.

For example, the number of electrodes in the lens stage, the arrangement and spacing between electrodes in the lens stage and the spacing between the lens stage and the sample may differ.

Other insulating materials, including silicon oxynitride, and other conductive materials, such as aluminium, may be used. It will be appreciated that choice of materials may depend on processing.

Values of electrode potentials can be adjusted. For example, electrode potentials may vary according to, among other things, primary beam energy, the number of electrodes in the lens stage, the arrangement and spacing between electrodes in the lens stage and spacing between the lens stage and the sample. These values can be found by computer modelling, as described earlier, and/or by routine experiment.

The charged particle beam system need not be a scanning electron microscope, but can be scanning ion microscope. Those skilled in the art will appreciate that the polarity of electrode potentials are reversed and that magnitudes many need to be adjusted.

The lens unit need not be arranged substantially parallel to the upper surface of the sample. For example, the lens unit may be canted at an angle. This arrangement may be helpful when the sample is small or if the lens unit is arranged on a finger having a tip or electrode at its distal end.

The aperture need not be disposed toward the proximate end, i.e. "backwards" of the cantilever. For example, the cantilever may be "rotated" with respect to the aperture or the aperture moved such that the aperture is to one side of the distal end of the cantilever or "forwards" of the distal end of the cantilever. Either of these arrangements can be used to reduce the separation between the tip and the aperture.

The scanning electron microscope system may be operated such that scanning probe microscopy, in particular atomic force microscopy, and scanning of the electron beam is carried out simultaneously.

The electron microscope system may be a transmission electron microscope system.

**Claims**

1. An electrostatic lens unit (23) for a charged particle beam system including:

   a substrate (35, 37) having first and second opposite faces (42, 43) and a passage (41) extending between first and second openings in the first and second faces respectively;
   first and second face electrodes (69, 81) supported on the first and second faces respectively; and
   a surface probe cantilever (25), formed by a slot in the substrate extending between the first and second opposite faces, the cantilever supporting a tip (26) for sensing sample separation when the sample is adjacent the second face, wherein the cantilever is laterally spaced from the passage;
   wherein the first and second face electrodes are arranged around the respective openings to the passage and arranged on and around the cantilever.

2. A unit according to claim 1, wherein the substrate (35, 37) includes an insulating sheet (40).

3. A unit according to claim 1 or 2, wherein the substrate (35, 37) comprises first and second portions, wherein the first portion (35) is thicker than the second portion (37).

4. A unit according to claim 3, wherein the first portion has a thickness of at least $5\mu$m and the second insulating sheet portion has a thickness no more than 5 $\mu$m.

5. A unit according to claim 3 or 4, wherein the first portion of the substrate supports the second insulating sheet portion around a peripheral edge.

6. A unit according to any one of claims 3 to 5, wherein the first and second portions share a layer (40) of insulating material.

7. A unit according to claim 6, wherein the insulating material in the layer comprises silicon nitride.

8. A unit according to any one of claims 3 to 7, wherein the first portion comprises another layer (39) of material.

9. A unit according to claim 8, wherein the material comprises silicon.

10. A unit according to claim 8 or 9, wherein the second portion does not include the second layer of material.

11. A unit according to any one of claims 3 to 10, wherein the substrate is arranged to provide a cantilever (25) extending from the first portion to the second portion.

12. A unit according to any preceding claim, comprising at least two electrodes supported on the second face arranged in a stack and around the openings to the passage.

13. A unit according to any preceding claim, comprising third, fourth and fifth electrodes (71, 72, 73) supported on the second face and arranged in a stack and around the openings to the passage.

14. A unit according to any preceding claim, wherein the probe does not obscure the aperture.

15. A unit according to any preceding claim, wherein the probe and the aperture are spaced apart by at least 10 $\mu$m, preferably at least 20 $\mu$m and more preferably at least $50\mu$m.

**16.** A unit according to claim 15, wherein the probe and the aperture are spaced apart by at least 100μm.

**17.** A unit according to any preceding claim, wherein the substrate is generally planar.

**18.** A unit according to claim 17, wherein the planar substrate is stepped.

**19.** Apparatus comprising:

a lens unit according to any preceding claim;
means (18) for supporting a sample; and
means (19, 20) for positioning the holder.

**20.** Apparatus according to claim 19, further comprising:

means (53, 54) for positioning the electrostatic lens unit relative to the sample holder.

**21.** Apparatus according to claim 20 or 21, further comprising:

a laser (49) arranged to direct light onto the unit; and
a detector (51) arranged to detect light reflected off the lens unit.

**22.** A charged particle beam system including:

apparatus according to claim 21 positioned downstream of an objective lens.

**23.** A method of operating a charged particle beam system which includes an electrostatic lens unit (23) comprising a substrate (35, 37) having first and second opposite faces (42, 43) and a passage (41) extending between first and second openings in the first and second faces respectively, first and second face electrodes (69, 81) supported on the first and second faces respectively, and a surface probe cantilever (25), formed by a slot in the substrate extending between the first and second opposite faces, the cantilever supporting a tip (26) for sensing sample separation wherein the first and second electrodes are arranged around the respective openings to the passage and arranged on and around the cantilever, the method comprising:

sensing separation between the lens unit and a sample;
directing a charged particle beam through the lens unit onto the sample; and
controlling the electrostatic lens unit to influence the charged particle beam including grounding the first electrode and applying a retarding potential to the second electrode and the sample.

**24.** A method according to claim 23, further comprising:

adjusting the separation between the lens unit and a sample while sensing the separation using the probe.

**25.** A method according to claim 23 or 24, further comprising:

determining topography of the sample using the probe prior to scanning the charged particle beam.

**26.** A method according to claim 25, comprising:

adjusting the separation between the lens unit and the sample in dependence upon said topography.

**27.** A method according to claim 25 or 26, comprising:

controlling the electrostatic lens unit so as to change focus in dependence upon said topography.

**Patentansprüche**

**1.** Elektrostatische Linseneinheit (23) für ein System für einen geladenen Teilchenstrahl, umfassend:

ein Substrat (35, 37) mit einer ersten und einer zweiten gegenüberliegenden Fläche (42, 43) und einem Durchlaß (41), der sich zwischen einer ersten und einer zweiten Öffnung in der ersten bzw. der zweiten Fläche erstreckt; eine erste und eine zweite Flächenelektrode (69, 81), die an der ersten bzw. der zweiten Fläche getragen sind; und

einen Oberflächensondencantilever (25), der durch einen Schlitz in dem Substrat gebildet ist, der sich zwischen der ersten und der zweiten gegenüberliegenden Fläche erstreckt, wobei der Cantilever eine Spitze (26) zum Abtasten des Probenabstands, wenn die Probe an die zweite Fläche grenzt, trägt, wobei der Cantilever in einem lateralen Abstand von dem Durchlaß angeordnet ist;

wobei die erste und die zweite Flächenelektrode um die jeweiligen Öffnungen zu dem Durchlaß angeordnet und auf und um den Cantilever angeordnet sind.

2. Einheit nach Anspruch 1, wobei das Substrat (35, 37) eine Isolierschicht (40) umfaßt.

3. Einheit nach Anspruch 1 oder 2, wobei das Substrat (35, 37) einen ersten und einen zweiten Bereich umfasst, wobei der erste Bereich (35) dicker als der zweite Bereich (37) ist.

4. Einheit nach Anspruch 3, wobei der erste Bereich eine Dicke von wenigstens 5 $\mu$m hat, und der zweite Isolierschichtbereich eine Dicke von nicht mehr als 5 $\mu$m hat.

5. Einheit nach Anspruch 3 oder 4, wobei der erste Bereich des Substrats den zweiten Isolierschichtbereich um eine periphere Kante trägt.

6. Einheit nach einem der Ansprüche 3 bis 5, wobei der erste und der zweite Bereich sich eine Schicht (40) eines isolierenden Materials teilen.

7. Einheit nach Anspruch 6, wobei das isolierende Material in der Schicht Siliziumnitrid umfasst.

8. Einheit nach einem der Ansprüche 3 bis 7, wobei der erste Bereich eine andere Materialschicht (39) umfasst.

9. Einheit nach Anspruch 8, wobei das Material Silizium umfasst.

10. Einheit nach Anspruch 8 oder 9, wobei der zweite Bereich nicht die zweite Materialschicht umfaßt.

11. Einheit nach einem der Ansprüche 3 bis 10, wobei das Substrat dazu ausgelegt ist, einen Cantilever (25), der sich von dem ersten Bereich zu dem zweiten Bereich erstreckt, bereitzustellen.

12. Einheit nach einem der vorhergehenden Ansprüche, umfassend wenigstens zwei Elektroden, die an der zweiten Fläche getragen sind und in einem Stapel und um die Öffnungen zu dem Durchlaß angeordnet sind.

13. Einheit nach einem der vorhergehenden Ansprüche, umfassend eine dritte, eine vierte und eine fünfte Elektrode (71, 72, 73), die an der zweiten Fläche getragen sind und in einem Stapel und um die Öffnungen zu dem Durchlaß angeordnet sind.

14. Einheit nach einem der vorhergehenden Ansprüche, wobei die Sonde nicht die Apertur verdeckt.

15. Einheit nach einem der vorhergehenden Ansprüche, wobei die Sonde und die Apertur in einem Abstand von wenigstens 10 $\mu$m voneinander angeordnet sind, bevorzugt wenigstens 20 $\mu$m und bevorzugter wenigstens 50 $\mu$m.

16. Einheit nach Anspruch 15, wobei die Sonde und die Apertur in einem Abstand von wenigstens 100 $\mu$m voneinander angeordnet sind.

17. Einheit nach einem der vorhergehenden Ansprüche, wobei das Substrat im Allgemeinen planar ist.

18. Einheit nach Anspruch 17, wobei das planare Substrat gestuft ist.

19. Apparat, umfassend:

eine Linseneinheit nach einem der vorhergehenden Ansprüche;

Mittel (18) zum Tragen einer Probe; und
Mittel (19, 20) zum Positionieren des Halters.

**20.** Apparat nach Anspruch 19, ferner umfassend:

Mittel (53, 54) zum Positionieren der elektrostatischen Linseneinheit relativ zu dem Probenhalter.

**21.** Apparat nach Anspruch 20 oder 21, ferner umfassend:

einen Laser (49), der dazu ausgelegt ist, Licht auf die Einheit zu richten;
und
einen Detektor (51), der dazu ausgelegt ist, von der Linseneinheit reflektiertes Licht zu detektieren.

**22.** System für einen geladenen Teilchenstrahl, umfassend:

einen Apparat nach Anspruch 21, der einer Objektivlinse nachgelagert positioniert ist.

**23.** Verfahren zum Betreiben eines Systems für einen geladenen Teilchenstrahl, welches eine elektrostatische Linseneinheit (23) umfaßt, umfassend ein Substrat (35, 37) mit einer ersten und einer zweiten gegenüberliegenden Fläche (42, 43) und einem Durchlaß (41), der sich zwischen einer ersten und einer zweiten Öffnung in der ersten bzw. der zweiten Fläche erstreckt, eine erste und eine zweite Flächenelektrode (69, 81), die an der ersten bzw. der zweiten Fläche getragen sind, und einen Oberflächensondencantilever (25), der durch einen Schlitz in dem Substrat gebildet ist, der sich zwischen der ersten und der zweiten gegenüberliegenden Fläche erstreckt, wobei der Cantilever eine Spitze (26) zum Abtasten des Probenabstands trägt, wobei die erste und die zweite Elektrode um die jeweiligen Öffnungen zu dem Durchlaß angeordnet und auf und um den Cantilever angeordnet sind, wobei das Verfahren umfaßt:

Abtasten des Abstands zwischen der Linseneinheit und einer Probe;
Richten eines geladenen Teilchenstrahls durch die Linseneinheit auf die Probe; und
Steuern der elektrostatischen Linseneinheit zum Beeinflussen des geladenen Teilchenstroms, umfassend Erden der ersten Elektrode und Anlegen eines retardierenden Potentials an die zweite Elektrode und die Probe.

**24.** Verfahren nach Anspruch 23, ferner umfassend:

Einstellen des Abstands zwischen der Linseneinheit und einer Probe während der Abtastung des Abstands unter Verwendung der Sonde.

**25.** Verfahren nach Anspruch 23 oder 24, ferner umfassend:

Bestimmen der Topographie der Probe unter Verwendung der Sonde vor dem Scannen des geladenen Teilchenstroms.

**26.** Verfahren nach Anspruch 25, umfassend:

Einstellen des Abstands zwischen der Linseneinheit und der Probe in Abhängigkeit von der Topographie.

**27.** Verfahren nach Anspruch 25 oder 26, ferner umfassend:

derartiges Steuern der elektrostatischen Linseneinheit, dass ein Fokus in Abhängigkeit von der Topographie geändert wird.

**Revendications**

**1.** Unité de lentille électrostatique (23) pour un système de faisceaux de particules chargées comportant :

un substrat (35, 37) ayant des première et deuxième faces opposées (42, 43) et un passage (41) s'étendant entre des première et deuxième ouvertures dans les première et deuxième faces respectivement ;

des première et deuxième électrodes de face (69, 81) soutenues sur les première et deuxième faces respectivement ; et

un bras en porte-à-faux (25) pour sonde de surface, formé par une fente dans le substrat s'étendant entre les première et deuxième faces opposées, le bras en porte-à-faux soutenant une pointe (26) pour détecter une séparation d'échantillon lorsque l'échantillon est adjacent à la deuxième face, où le bras en porte-à-faux est latéralement espacé du passage ;

où les première et deuxième électrodes de face sont agencées autour des ouvertures respectives au passage et agencées sur le bras en porte-à-faux et autour de celui-ci.

2. Unité selon la revendication 1, dans laquelle le substrat (35, 37) comporte une feuille isolante (40).

3. Unité selon la revendication 1 ou 2, dans laquelle le substrat (35, 37) comprend des première et deuxième parties, où la première partie (35) est plus épaisse que la deuxième partie (37).

4. Unité selon la revendication 3, dans laquelle la première partie a une épaisseur d'au moins 5 $\mu$m et la deuxième partie de feuille isolante a une épaisseur de pas plus de 5$\mu$m.

5. Unité selon la revendication 3 ou 4, dans laquelle la première partie du substrat soutient la deuxième partie de feuille isolante autour d'un bord périphérique.

6. Unité selon l'une quelconque des revendications 3 à 5, dans laquelle les première et deuxième parties partagent une couche (40) de matériau isolant.

7. Unité selon la revendication 6, dans laquelle le matériau isolant dans la couche comprend du nitrure de silicium.

8. Unité selon l'une quelconque des revendications 3 à 7, dans laquelle la première partie comprend une autre couche (39) de matériau.

9. Unité selon la revendication 8, dans laquelle le matériau comprend du silicium.

10. Unité selon la revendication 8 ou 9, dans laquelle la deuxième partie ne comporte pas la deuxième couche de matériau.

11. Unité selon l'une quelconque des revendications 3 à 10, dans laquelle le substrat est agencé de sorte à prévoir un bras en porte-à-faux (25) s'étendant de la première partie à la deuxième partie.

12. Unité selon l'une des revendications précédentes, comprenant au moins deux électrodes soutenues sur la deuxième face, agencées en un empilement et autour des ouvertures du passage.

13. Unité selon l'une des revendications précédentes, comprenant des troisième, quatrième et cinquième électrodes (71, 72, 73) soutenues sur la deuxième face et agencées en un empilement et autour des ouvertures du passage.

14. Unité selon l'une des revendications précédentes, dans laquelle la sonde ne cache pas l'ouverture.

15. Unité selon l'une des revendications précédentes, dans laquelle la sonde et l'ouverture sont espacées par au moins 10$\mu$m, préférablement au moins 20$\mu$m et plus préférablement au moins 50$\mu$m.

16. Unité selon la revendication 15, dans laquelle la sonde et l'ouverture sont espacées par au moins 100$\mu$m.

17. Unité selon l'une des revendications précédentes, dans laquelle le substrat est généralement plan.

18. Unité selon la revendication 17, dans laquelle le substrat plan est étagé.

19. Appareil comprenant :

une unité de lentille selon l'une des revendications précédentes ;
un moyen (18) pour soutenir un échantillon ; et
un moyen (19, 20) pour positionner le support.

**20.** Appareil selon la revendication 19, comprenant en plus :

un moyen (53, 54) pour positionner l'unité de lentille électrostatique par rapport au support d'échantillon.

**21.** Appareil selon la revendication 20 ou 21, comprenant en plus :

un laser (49) agencé pour diriger la lumière sur l'unité ; et
un détecteur (51) agencé pour détecter la lumière réfléchie hors de l'unité de lentille.

**22.** Système à faisceaux de particules chargées comportant :

un appareil selon la revendication 21, positionné en aval d'une lentille d'objectif.

**23.** Procédé destiné à faire fonctionner un système à faisceaux de particules chargées qui comporte une unité de lentille électrostatique (23) comprenant un substrat (35, 37) avec des première et deuxième faces opposées (42, 43) et un passage (41) s'étendant entre des première et deuxième ouvertures dans les première et deuxième faces respectivement, des première et deuxième électrodes de face (69, 81) soutenues sur les première et deuxième faces respectivement, et un bras en porte-à-faux (25) pour sonde de surface, formé par une fente dans le substrat s'étendant entre les première et deuxième faces opposées, le bras en porte-à-faux soutenant une pointe (26) pour détecter une séparation d'échantillon où les première et deuxième électrodes sont agencées autour des ouvertures respectives du passage et agencées sur le bras en porte-à-faux et autour de celui-ci, le procédé comprenant le fait :

de détecter une séparation entre l'unité de lentille et un échantillon ;
de diriger un faisceau de particules chargées à travers l'unité de lentille sur l'échantillon ; et
de commander l'unité de lentille électrostatique pour influencer le faisceau de particules chargées comportant la mise à la masse de la première électrode et appliquant un potentiel retardé à la deuxième électrode et à l'échantillon.

**24.** Procédé selon la revendication 23, comprenant en plus le fait :

de régler la séparation entre l'unité de lentille et un échantillon tout en détectant la séparation en utilisant la sonde.

**25.** Procédé selon la revendication 23 ou 24, comprenant en plus le fait :

de déterminer une topographie de l'échantillon en utilisant la sonde avant de balayer le faisceau de particules chargées.

**26.** Procédé selon la revendication 25, comprenant le fait :

de régler la séparation entre l'unité de lentille et l'échantillon en fonction de ladite topographie.

**27.** Procédé selon la revendication 25 ou 26, comprenant le fait :

de commander l'unité de lentille électrostatique afin de changer la focalisation en fonction de ladite topographie.

Fig. 1

Fig. 2

EP 2 023 372 B1

Fig. 3

Fig. 4

Fig. 5a

Fig. 5b

Fig. 6

Fig. 7

Fig. 8

26

Fig. 9

Fig. 10

Fig. 11

Fig. 12

```
          ┌─────────┐
          │  Start  │
          └────┬────┘
               ▼
     ┌─────────────────┐
     │  Silicon wafer  │   S1
     └────────┬────────┘
              ▼
     ┌─────────────────┐
     │ Deposit dielectric │  S2
     │ on first side of wafer │
     └────────┬────────┘
              ▼
     ┌─────────────────┐
     │ Define etch mask on │  S3
     │ second side of wafer │
     └────────┬────────┘
              ▼
     ┌─────────────────┐
     │ Etch silicon from │  S4
     │ second side of wafer │
     └────────┬────────┘
              ▼
     ┌─────────────────┐
     │ Define etch mask │  S5
     │ on membrane │
     └────────┬────────┘
              ▼
     ┌─────────────────┐
     │ Etch from │  S6
     │ second side of wafer │
     └────────┬────────┘
              ▼
     ┌─────────────────┐
     │ Deposit conductive │
     │ coating over dielectric │
     │ membrane and etched │  S7
     │ silicon on second side │
     └────────┬────────┘
              ▼
     ┌─────────────────┐
     │ Deposit │  S8
     │ conductive coating │
     └────────┬────────┘
              ▼
     ┌─────────────────┐
     │ Deposit │  S9
     │ dielectric coating │
     └────────┬────────┘
      n times ▼
     ┌─────────────────┐
     │ Deposit │  S10
     │ conductive coating │
     └────────┬────────┘
              ▼
     ┌─────────────────┐
     │ Define etch mask │  S11
     └────────┬────────┘
              ▼
     ┌─────────────────┐
     │ Etch layers │  S12
     └────────┬────────┘
   n+1 times  ▼
          ┌─────┐
          │  A  │
          └─────┘
```

Membrane
formation

Back side
electrode
formation

Front side
electrode layers
deposition

Front side
electrode stack
patterning

Fig. 13

(A)

| | |
|---|---|
| Define lift off mask | S13 |
| Deposit dielectric coating | S14 |
| Lift off | S15 |
| Define etch mask | S16 |
| Etch dielectric coating | S17 |
| Define lift off mask | S18 |
| Deposit conductive and protective coatings | S19 |
| Liftoff | S20 |

Front side electrode leads formation

| | |
|---|---|
| Deposit dielectric coating | S21 |
| Deposit conductive coating | S22 |
| Define etch mask | S23 |
| Etch conductive coating | S24 |
| Etch dielectric coating | S25 |
| Etch conductive coating | S26 |

Front side 'screen' electrode formation

(B)

Fig. 13

B

| Coat both sides with protective coating | S27 |

| Focused ion beam etching | S28 |

| Wet etching | S29 |

| Remove protective coating | S30 |

Cantilever & aperture formation

| Electron beam induced deposition | S31 |

Tip formation

| Mount in holder | S32 |

End

## Fig. 13

(a)

99

97

98

(b)

$t_2$

97

100

98

## Fig. 14

(c)

102    99

101

97

100

(d)

$t_1$

104  103    99'

97'

100

(e)

106    99'

105

97'

100

(f)

35    37    99"

97"

100

(g)

107  108    99"

97"

100

109

(h)

97"

100

110

109

114

115

111

112

113

Fig. 14

Fig. 15

Fig. 15

Fig. 16

(a)

81'

78

113'

112', 115'

77, 79

100'

117

111', 114'

78

76

81'

81'

(b)

78

113'

112', 115'

77, 79

117

82'

111', 114'

78

76

(c)

78

113'

112', 115'

77, 79

117

82

111', 114'

78

76

Fig. 17

36

Start

Retract raised lens unit — S33

Position sample using standard SEM imaging — S34

Insert lens unit — S35

F

Lower the lens unit — S36

Desired lens – sample separation? — S37

No

Yes

Align beam to lens centre — S38

Step-in mode? — S39

Yes → C

No → D

E

Finished? — S48

No

Yes

End

F

Fig. 18

Fig. 18

Fig. 18

G

Topography
compensation?          No          S59

Yes

Position          Adjust
position or          Focus
focus?          S60

Adjust sample
z poistion for focus          S61

Adjust electrode
potentials to focus at z          S62

Store scattered
electron data          S63

No          Reached
H          scan limits?          S64

Yes

Raise lens unit  by $\Delta z_2$          S65

E

Fig. 18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5789748 A
- EP 1134771 A
- WO 2007096505 A
- WO 0067290 A
- US 6878937 B

### Non-patent literature cited in the description

- **J. MEIJER et al.** Concept of deterministic single ion doping with sub-nm spatial resolution. *Applied Physics A,* 2006, vol. 83, 321-327
- **R. M. TROMP.** Low-energy electron microscopy. *IBM Journal of Research and Development,* 2000, vol. 44, 503-516
- **J. H. KINDT et al.** Automated wafer-scale fabrication of electron beam deposited tips for atomic force microscopes using pattern recognition. *Nanotechnology,* 2004, vol. 15, 1131